# EUROPEAN PATENT APPLICATION

(11) **EP 3 974 497 A1**
(43) Date of publication of application: **30.03.2022**
(21) Application number: 20808755.1
(22) Date of filing: 13.05.2020
(51) Int. Cl.: C09K 11/08, B82Y 20/00, B82Y 40/00, C08F 2/50, C09D 11/037, H05B 33/14

(54) **METHOD FOR PRODUCING LIGHT EMITTING PARTICLES, LIGHT EMITTING PARTICLES, LIGHT EMITTING PARTICLE DISPERSION, INK COMPOSITION AND LIGHT EMITTING ELEMENT**

(30) Priority: 21.05.2019 JP 2019095110
(71) Applicant: DIC Corporation, Tokyo 174-8520 (JP)
(72) Inventor: ENDO Koichi, Kitaadachi-gun, Saitama 362-8577 (JP); UMEZU Yasuo, Kitaadachi-gun, Saitama 362-8577 (JP); AOKI Yoshio, Kitaadachi-gun, Saitama 362-8577 (JP); HIRATA Shinichi, Kitaadachi-gun, Saitama 362-8577 (JP); HAYASHI Takuo, Kitaadachi-gun, Saitama 362-8577 (JP); HORIGUCHI Masahiro, Kitaadachi-gun, Saitama 362-8577 (JP); HORIGOME Misao, Kitaadachi-gun, Saitama 362-8577 (JP); YUAN Jianjun, Kitaadachi-gun, Saitama 362-8577 (JP)
(74) Representative: Beckmann, Claus
(86) International application number: PCT/JP2020/019142
(87) International publication number: WO 2020/235420

(57) **Abstract**

[Means for Resolution] Provided are light-emitting particles having high stability while having perovskite-type semiconductor nanocrystals having excellent light-emitting properties, a method for producing the same, and a light-emitting particle dispersion, an ink composition, and a light-emitting element containing such light-emitting particles. The method for producing light-emitting particles of the present invention includes a step of preparing parent particles 91 composed of perovskite-type semiconductor nanocrystals 911 having light-emitting properties and a surface layer 912 which is composed of ligands coordinated on the surface of the semiconductor nanocrystal 911 and in which the ligand molecules form a siloxane bond with each other, and a step of forming a polymer layer 93 by coating the surface of the parent particle 91 with a hydrophobic polymer.

## Description

### Technical Field

The present invention relates to a method for producing light-emitting particles, light-emitting particles, a light-emitting particle dispersion, an ink composition, and a light-emitting element.

### Background Art

International standard BT.2020 (Broadcasting service 2020) required for next-generation display elements is an extremely ambitious standard, and it is difficult to meet it even with current color filters and organic EL using pigments.

On the other hand, semiconductor nanocrystals with light-emitting properties are materials that emit fluorescence or phosphorescence with a narrow half-value width of emission wavelength and are attracting attention as a material that can satisfy BT.2020. Initially, CdSe and the like were used as semiconductor nanocrystals, but recently, InP and the like have been used in order to avoid harmfulness thereof.

However, the stability of InP is low and vigorous efforts are being made with the aim of improving the stability. In addition, since the emission wavelength of semiconductor nanocrystals such as InP is determined by the particle size, it is necessary to precisely control the dispersion of the particle size in order to obtain light emission with a narrow half-value width and there are many problems in the production thereof.

In recent years, semiconductor nanocrystals having a perovskite-type crystal structure have been discovered and are attracting attention (see, for example, PTL 1). A common perovskite-type semiconductor nanocrystal is a compound represented by CsPbX₃ (X represents Cl, Br or I) . In addition to the particle size, perovskite-type semiconductor nanocrystals can control the emission wavelength by adjusting the abundance ratio of halogen atoms. Since this adjustment operation can be easily performed, the perovskite-type semiconductor nanocrystal is characterized in that the emission wavelength is more easily controlled and therefore the productivity is higher than that of the semiconductor nanocrystal such as InP.

As described above, the perovskite-type semiconductor nanocrystal has extremely excellent light-emitting properties but has a problem that it is easily destabilized by oxygen, moisture, heat, and the like. Therefore, it is necessary to improve the stability of perovskite-type semiconductor nanocrystals by some method.

### Citation List

### Patent Literature

PTL 1: JP-A-2017-222851

### Summary of Invention

### Technical Problem

An object of the present invention is to provide light-emitting particles having high stability while having perovskite-type semiconductor nanocrystals having excellent light-emitting properties, a method for producing the same, and a light-emitting particle dispersion, an ink composition, and a light-emitting element containing such light-emitting particles.

### Solution to Problem

Such an object is achieved by the following inventions (1) to (16).
(1) A method for producing light-emitting particles including:
   step 1 of mixing a solution containing a raw material compound for semiconductor nanocrystals and a solution containing a compound containing Si and having a reactive group capable of forming a siloxane bond to precipitate perovskite-type semiconductor nanocrystals having light emitting properties and coordinate the compound on the surfaces of semiconductor nanocrystal, and then condensing the reactive group in the coordinated compound to obtain parent particles each having a surface layer having the siloxane bond formed on the surface of the semiconductor nanocrystal, and
   step 2 of then forming a polymer layer by coating the surface of each parent particle with a hydrophobic polymer.
(2) The method for producing light-emitting particles according to (1) above, where the average particle size of the semiconductor nanocrystals is 40 nm or less.
(3) The method for producing light-emitting particles according to (1) or (2) above, where the surface layer has a thickness of 0.5 to 50 nm.
(4) The method for producing light-emitting particles according to any one of (1) to (3) above, where the compound having a reactive group has a binding group that binds to a cation contained in the semiconductor nanocrystal.
(5) The method for producing light-emitting particles according to (4) above, where the binding group is at least one of a carboxyl group, a mercapto group, and an amino group.
(6) The method for producing light-emitting particles according to any one of (1) to (5) above, where the polymer layer has a thickness of 5 to 100 nm.
(7) The method for producing light-emitting particles according to any one of (1) to (6) above, where the hydrophobic polymer is obtained by carrying at least one polymerizable unsaturated monomer that is soluble in a non-aqueous solvent and becomes insoluble or sparingly soluble after polymerization, together with a polymer having a polymerizable unsaturated group soluble in a non-aqueous solvent on the surface of the parent particle and then polymerizing the polymer and the polymerizable unsaturated monomer.
(8) The method for producing light-emitting particles according to (7) above, where the non-aqueous solvent contains at least one of an aliphatic hydrocarbon solvent and an alicyclic hydrocarbon solvent.
(9) Light-emitting particles each including
   a parent particle composed of a perovskite-type semiconductor nanocrystal having light-emitting properties, and a surface layer which is composed of ligands coordinated on the surface of the semiconductor nanocrystal and in which ligand molecules form a siloxane bond, and
   a polymer layer which covers the surface of the parent particle and is composed of a hydrophobic polymer.
(10) The light-emitting particles according to (9) above, where the hydrophobic polymer is a polymer having a polymerizable unsaturated group soluble in a non-aqueous solvent and at least one polymerizable unsaturated monomer that is soluble in a non-aqueous solvent and becomes insoluble or sparingly soluble after polymerization.
(11) A light-emitting particle dispersion comprising the light-emitting particles according to (9) or (10) above and a dispersion medium for dispersing the light-emitting particles.
(12) An ink composition comprising the light-emitting particles according to (9) or (10) above, a photopolymerizable compound, and a photopolymerization initiator.
(13) The ink composition according to (12) above, where the photopolymerizable compound is a photoradical polymerizable compound.
(14) The ink composition according to (12) or (13) above, where the photopolymerization initiator is at least one selected from the group consisting of alkylphenone compounds, acylphosphine oxide compounds, and oxime ester compounds.
(15) A light-emitting element comprising a light-emitting layer containing the light-emitting particles according to (9) or (10) above.
(16) The light-emitting element according to (15) above, further including a light source unit that irradiates the light-emitting layer with light.

### Advantageous Effects of Invention

According to the present invention, light-emitting particles having excellent light-emitting properties and high stability due to the presence of a surface layer and a polymer layer can be obtained.

### Brief Description of Drawings

Fig. 1 is a cross-sectional view showing an embodiment of a light-emitting particle of the present invention.
Fig. 2 is a cross-sectional view showing an embodiment of the light-emitting element of the present invention.
Fig. 3 is a schematic diagram showing a configuration of an active matrix circuit.
Fig. 4 is a schematic diagram showing a configuration of an active matrix circuit.

### Description of Embodiments

Hereinafter, the method for producing light-emitting particles, the light-emitting particles, the light-emitting particle dispersion, the ink composition, and the light-emitting element of the present invention will be described in detail based on the preferable embodiments shown in the accompanying drawings.

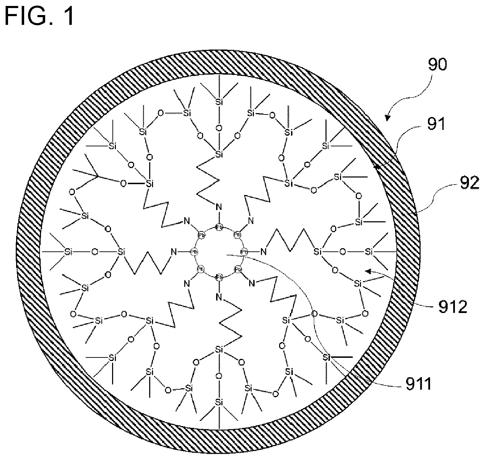

Fig. 1 is a cross-sectional view showing an embodiment of a light-emitting particle of the present invention.

### <Light-Emitting Particles and Method for Producing the Same>

A light-emitting particle 90 shown in Fig. 1 includes a parent particle 91 having a perovskite-type semiconductor nanocrystal having light-emitting properties (hereinafter, may be simply referred to as "nanocrystal 911") and a surface layer 912 which is composed of ligands coordinated on the surface of the nanocrystal 911 and in which the ligand molecules form a siloxane bond, and a polymer layer 92 covering the surface of the parent particle 91 and composed of a hydrophobic polymer. Therefore, since the nanocrystals 911 are protected by the surface layer 912 and the polymer layer 92, the light-emitting particles 90 can exhibit high stability against oxygen, water, heat, and the like while maintaining excellent light-emitting properties.

Such light-emitting particles 90 can be produced by a method (method for producing a light-emitting element of the present invention) including step 1 of mixing a solution containing a raw material compound for semiconductor nanocrystals and a solution containing a compound containing Si and having a reactive group capable of forming a siloxane bond to precipitate perovskite-type semiconductor nanocrystals having light-emitting properties and coordinate the compound on the surfaces of the semiconductor nanocrystals, and then condensing the reactive group in the coordinated compound to obtain parent particles having a surface layer having the siloxane bond formed on the surface of the semiconductor nanocrystal, and step 2 of then forming a polymer layer by coating the surface of each parent particle with a hydrophobic polymer.

### <<Step 1 (Parent Particle Preparation Step)>>

First, to describe step 1 in detail, the light-emitting particles 91 obtained through step 1 are the parent particles in the next step, step 2, and each have the nanocrystal 911 and the surface layer 912 covering the nanocrystal 911. The parent particle 91 per se can be used alone as a light-emitting particle.

### [Nanocrystal 911]

The nanocrystal 911 obtained through step 1 is a nano-sized crystal (nanocrystal particle) that has a perovskite-type crystal structure and absorbs excitation light to emit fluorescence or phosphorescence. The nanocrystal 911 is, for example, a crystal having a maximum particle size of 100 nm or less as measured by a transmission electron microscope or a scanning electron microscope.

The nanocrystal 911 can be excited by, for example, light energy or electrical energy of a predetermined wavelength and emit fluorescence or phosphorescence.

The nanocrystal 911 having a perovskite-type crystal structure is a compound represented by the general formula: AₐM_{b}X_{c}.

In the formula, A is at least one among organic cations and metal cations. Examples of the organic cation include ammonium, formamidinium, guanidinium, imidazolium, pyridinium, pyrrolidinium, protonated thiourea, and the like, and examples of the metal cation include cations of Cs, Rb, K, Na, Li, and the like.

M is at least one of metal cations. Examples of the metal cation include cations of Ag, Au, Bi, Ca, Ce, Co, Cr, Cu, Eu, Fe, Ga, Ge, Hf, In, Ir, Mg, Mn, Mo, Na, Nb, Nd, Ni, Os, Pb, Pd, Pt, Re, Rh, Ru, Sb, Sm, Sn, Sr, Te, Ti, V, W, Zn, Zr, and the like.

X is at least one of anions. Examples of the anion include chloride ion, bromide ion, iodide ion, cyanide ion, and the like.

a is 1 to 4, b is 1 to 2, and c is 3 to 9.

The emission wavelength (emission color) of such a nanocrystal 911 can be controlled by adjusting the particle size, the type and abundance ratio of the anions constituting the X site.

As a specific composition of the nanocrystal 911, the nanocrystal 911 using Pb as M, such as CsPbBr₃, CH₃NH₃PbBr₃, and CHN₂H₄PbBr₃ is preferable due to the excellent light intensity and quantum efficiency. Further, the nanocrystal 911 using a metal cation other than Pb as M such as CsPbBr₃, CH₃NH₃PbBr₃, and CHN₂H₄PbBr₃ is preferable due to the low toxicity and a little impact on the environment.

The nanocrystal 911 may be a red light-emitting crystal that emits light having an emission peak in the wavelength range of 605 to 665 nm (red light), may be a green light-emitting crystal that emits light having an emission peak in the wavelength range of 500 to 560 nm (green light), and may be a blue light-emitting crystal that emits light having an emission peak in the wavelength range of 420 to 480 nm (blue light). Further, in one embodiment, a combination of these nanocrystals may be used.

Note that the wavelength of the emission peak of the nanocrystal 911 can be determined, for example, in the fluorescence spectrum or the phosphorescence spectrum measured by using an absolute PL quantum yield measuring device.

The red light-emitting nanocrystals 911 preferably have an emission peak in the wavelength range of 665 nm or less, 663 nm or less, 660 nm or less, 658 nm or less, 655 nm or less, 653 nm or less, 651 nm or less, 650 nm or less, 647 nm or less, 645 nm or less, 643 nm or less, 640 nm or less, 637 nm or less, 635 nm or less, 632 nm or less, or 630 nm or less, and preferably have an emission peak in the wavelength range of 628 nm or more, 625 nm or more, 623 nm or more, 620 nm or more, 615 nm or more, 610 nm or more, 607 nm or more, or 605 nm or more.

These upper limit value and lower limit value can be arbitrarily combined. Note that in the similar description below, the upper limit value and the lower limit value described individually can be arbitrarily combined.

The green light-emitting nanocrystals 911 preferably have an emission peak in the wavelength range of 560 nm or less, 557 nm or less, 555 nm or less, 550 nm or less, 547 nm or less, 545 nm or less, 543 nm or less, 540 nm or less, 537 nm or less, 535 nm or less, 532 nm or less, or 530 nm or less, and preferably have an emission peak in the wavelength range of 528 nm or more, 525 nm or more, 523 nm or more, 520 nm or more, 515 nm or more, 510 nm or more, 507 nm or more, 505 nm or more, 503 nm or more, or 500 nm or more.

The blue light-emitting nanocrystals 911 preferably have an emission peak in the wavelength range of 480 nm or less, 477 nm or less, 475 nm or less, 470 nm or less, 467 nm or less, 465 nm or less, 463 nm or less, 460 nm or less, 457 nm or less, 455 nm or less, 452 nm or less, or 450 nm or less, and preferably have an emission peak in the wavelength range of 450 nm or more, 445 nm or more, 440 nm or more, 435 nm or more, 430 nm or more, 428 nm or more, 425 nm or more, 422 nm or more, or 420 nm or more.

The shape of the nanocrystal 911 is not particularly limited and may be any geometric shape or any irregular shape. Examples of the shape of the nanocrystal 911 include a rectangular parallelepiped shape, a cube shape, a spherical shape, a regular tetrahedron shape, an ellipsoidal shape, a pyramid shape, a disc shape, a branch shape, a net shape, and a rod shape. Note that the shape of the nanocrystal 911 is preferably a shape having little directionality (for example, a spherical shape, a regular tetrahedron shape, and the like) . By using the nanocrystals 911 having such a shape, the light-emitting particles 90 reflecting the shape can be obtained, and uniform dispersibility and fluidity when an ink composition containing the light-emitting particles 90 is prepared can be further enhanced.

The average particle size (volume average diameter) of the nanocrystals 911 is preferably 40 nm or less, more preferably 30 nm or less, and even more preferably 20 nm or less. Note that the average particle size of the nanocrystals 911 is preferably 1 nm or more, more preferably 1.5 nm or more, and even more preferably 2 nm or more. The nanocrystals 911 having such an average particle size are preferable since they easily emit light having a desired wavelength.

Note that the average particle size of the nanocrystals 911 is obtained by measuring with a transmission electron microscope or a scanning electron microscope and calculating the volume average diameter.

By the way, the nanocrystals 911 have surface atoms that can serve as coordination sites, and thus have high reactivity. The nanocrystals 911 have such high reactivity and have a large surface area as compared with general pigments, which facilitates aggregation in the ink composition.

The nanocrystals 911 emit light due to the quantum size effect. Therefore, when the nanocrystals 911 aggregate, a quenching phenomenon occurs, which causes a decrease in the fluorescence quantum yield and a decrease in brightness and color reproducibility. In the present invention, since the nanocrystal 911 is coated with the surface layer 912 and the polymer layer 92, the light-emitting particles 90 are less likely to aggregate even when the ink composition was prepared, and the deterioration of light-emitting properties due to the aggregation are less likely to occur.

### [Surface Layer 912]

The surface layer 912 obtained through step 1 is composed of ligands capable of coordinating with the surface of the nanocrystal 911 and capable of forming a siloxane bond between the molecules.

Such a ligand is a compound containing Si and having a reactive group forming a siloxane bond. Preferably, this compound further has a binding group that binds to a cation contained in the nanocrystal 911.

As the reactive group, a hydrolyzable silyl group such as a silanol group or an alkoxysilyl group having 1 to 6 carbon atoms is preferable in that a siloxane bond is easily formed.

Examples of the binding group include a carboxyl group, an amino group, an ammonium group, a mercapto group, a phosphine group, a phosphine oxide group, a phosphoric acid group, a phosphonic acid group, a phosphinic acid group, a sulfonic acid group, a boronic acid group, and the like. Among them, the binding group is preferably at least one of a carboxyl group, a mercapto group, and an amino group. These binding groups have a higher affinity for the cations contained in the nanocrystal 911 than the reactive group described above. Therefore, the ligand can coordinate with the binding group on the nanocrystal 911 side, and can more easily and surely form the surface layer 912.

As such a ligand, one or more types of silicon compounds containing a binding group can be contained, or two or more types can be used in a combination.

Preferably, any one of a carboxyl group-containing silicon compound, an amino group-containing silicon compound, and a mercapto group-containing silicon compound can be contained, or two or more of them can be used in a combination.

Specific examples of the carboxyl group-containing silicon compound include, for example, 3-(trimethoxysilyl) propionic acid, 3-(triethoxysilyl) propionic acid, 2-, carboxyethylphenylbis(2-methoxyethoxy)silane, N-[3-(trimethoxysilyl)propyl]-N'-carboxymethylethylenediamine, N-[3-(trimethoxysilyl)propyl]phthalamide, N-[3-(trimethoxysilyl)propyl]ethylenediamine-N,N',N'-triacetic acid, and the like.

On the other hand, specific examples of the amino group-containing silicon compound include, for example, 3-aminopropyltrimethoxysilane, 3-aminopropyltriethoxysilane, N-(2-aminoethyl)-3-aminopropylmethyldimethoxysilane, N-(2-aminoethyl)-3-aminopropylmethylethoxysilane, N-(2-aminoethyl)-3-aminopropylmethyldipropoxysilane, N-(2-aminoethyl)-3-aminopropylmethyldiisopropoxysilane, N-(2-aminoethyl)-3-aminopropyltrimethoxysilane, N-(2-aminoethyl)-3-aminopropyltriethoxysilane, N-(2-aminoethyl)-3-aminopropyltripropoxysilane, N-(2-aminoethyl)-3-aminopropyltriisopropoxysilane, N-(2-aminoethyl)-3-aminoisobutyldimethylmethoxysilane, N-(2-aminoethyl)-3-aminoisobutylmethyldimethoxysilane, N-(2-aminoethyl)-11-aminoundecyltrimethoxysilane, N-(2-aminoethyl)-3-aminopropylsilanetriol, 3-triethoxysilyl-N-(1,3-dimethylbutylidene)propylamine, N-phenyl-3-aminopropyltrimethoxysilane, N,N-bis[3-(trimethoxysilyl)propyl]ethylenediamine, (aminoethylaminoethyl)phenyltrimethoxysilane, (aminoethylaminoethyl)phenyltriethoxysilane, (aminoethylaminoethyl)phenyltripropoxysilane, (aminoethylaminoethyl)phenyltriisopropoxysilane, (aminoethylaminomethyl)phenyltrimethoxysilane, (aminoethylaminomethyl)phenyltriethoxysilane, (aminoethylaminomethyl)phenyltripropoxysilane, (aminoethylaminomethyl)phenyltriisopropoxysilane, N-(vinylbenzyl)-2-aminoethyl-3-aminopropyltrimethoxysilane, N-(vinylbenzyl)-2-aminoethyl-3-aminopropylmethyldimethoxysilane, N-β-(N-vinylbenzylaminoethyl)-N-γ-(N-vinylbenzyl)-γ-aminopropyltrimethoxysilane, N-β-(N-di(vinylbenzyl)aminoethyl)-γ-aminopropyltrimethoxysilane, N-β-(N-di(vinylbenzyl)aminoethyl)-N-γ-(N-vinylbenzyl)-γ-aminopropyltrimethoxysilane, methylbenzylaminoethylaminopropyltrimethoxysilane, dimethylbenzylaminoethylaminopropyltrimethoxysilane, benzylaminoethylaminopropyltrimethoxysilane, benzylaminoethylaminopropyltriethoxysilane, 3-ureidopropyltriethoxysilane, 3-(N-phenyl)aminopropyltrimethoxysilane, N,N-bis[3-(trimethoxysilyl)propyl]ethylenediamine, (aminoethylaminoethyl)phenethyltrimethoxysilane, (aminoethylaminoethyl)phenethyltriethoxysilane, (aminoethylaminoethyl)phenethyltripropoxysilane, (aminoethylaminoethyl)phenethyltriisopropoxysilane, (aminoethylaminomethyl)phenethyltrimethoxysilane, (aminoethylaminomethyl)phenethyltriethoxysilane, (aminoethylaminomethyl)phenethyltripropoxysilane, (aminoethylaminomethyl)phenethyltriisopropoxysilane, N-[2-[3-(triemethoxysilyl)propylamino]ethyl]ethylenediamine, N-[2-[3-(triethoxysilyl)propylamino]ethyl]ethylenediamine, N-[2-[3-(tripropoxysilyl)propylamino]ethyl]ethylenediamine, N-[2-[3-(triisopropoxysilyl)propylamino]ethyl]ethylenediamine, and the like.

Specific examples of the mercapto group-containing silicon compound include, for example, 3-mercaptopropyltrimethoxysilane, 3-mercaptopropyltriethoxysilane, 3-mercaptopropylmethyldimethoxysilane, 3-mercaptopropylmethyldiethoxysilane, 2-mercaptoethyltrimethoxysilane, 2-mercaptoethyltriethoxysilane, 2-mercaptoethylmethyldimethoxysilane, 2-mercaptoethylmethyldiethoxysilane, 3-[ethoxybis(3,6,9,12,15-pentaoxaoctacosan-1-yloxy)silyl]-1-propanthiol, and the like.

Fig. 1 shows an example of the parent particle 91. The parent particle 91 shown in Fig. 1 has the surface layer 912 formed by coordinating 3-aminopropyltrimethoxysilane as a ligand on the surface of the nanocrystal 911 containing a Pb cation as an M site.

The thickness of the surface layer 912 is preferably 0.5 to 50 nm, and more preferably 1.0 to 30 nm. If the light-emitting particles 90 (parent particles 91) have the surface layer 912 having such a thickness, the stability of the nanocrystals 911 with respect to heat can be sufficiently enhanced.

Note that the thickness of the surface layer 912 can be changed by adjusting the number of atoms (chain length) of the linking structure that connects the binding group and the reactive group of the ligand.

Such a parent particle 91 can be easily prepared by mixing a solution containing the raw material compound of the nanocrystal 911 and a solution containing a compound containing Si and having a reactive group capable of forming a siloxane bond, and then condensing the reactive group coordinated on the surface of the precipitated nanocrystal 911. At this time, there are a production method with heating and a production method without heating.

First, a method of producing the parent particles 91 by heating will be described. Two solutions respectively containing a raw material compound for synthesizing semiconductor nanocrystals by a reaction are prepared, respectively. At this time, a compound containing Si and having a reactive group capable of forming a siloxane bond is added to either of the two solutions. Then, these are mixed under an inert gas atmosphere and reacted under temperature conditions of 140 to 260°C. Then, a method of precipitating nanocrystals by cooling to -20 to 30°C and stirring can be mentioned. The precipitated nanocrystals 911 have the surface layer 912 having a siloxane bond formed on the surface thereof, and the nanocrystals can be obtained by a conventional method such as centrifugation.

Specifically, for example, a solution containing cesium carbonate, oleic acid, and an organic solvent is prepared. As the organic solvent, 1-octadecene, dioctyl ether, diphenyl ether, and the like can be used. At this time, it is preferable to adjust the addition amount of cesium carbonate having 0.2 to 2 g and the addition amount of oleic acid having 0.1 to 10 mL with respect to 40 mL of the organic solvent. The obtained solution is dried under reduced pressure at 90 to 150°C for 10 to 180 minutes, and then heated at 100 to 200°C under an atmosphere of an inert gas such as argon or nitrogen to obtain a cesium-oleic acid solution.

On the other hand, a solution containing lead (II) bromide and the organic solvent same as the one described above is prepared. At this time, 20 to 100 mg of lead (II) bromide is added to 5 mL of the organic solvent. The obtained solution is dried under reduced pressure at 90 to 150°C for 10 to 180 minutes, and then 0.1 to 2 mL of 3-aminopropyltriethoxysilane is added under an atmosphere of an inert gas such as argon or nitrogen.

Then, the above-mentioned cesium-oleic acid solution is added in a state where the solution containing lead (II) bromide and 3-aminopropyltriethoxysilane is heated to 140 to 260°C, and the reaction is carried out by heating and stirring for 1 to 10 seconds. Then, the obtained reaction solution is cooled in an ice bath. At this time, it is preferable to add 0.1 to 1 mL of the cesium-oleic acid solution to 5 mL of the solution containing lead (II) bromide and 3-aminopropyltriethoxysilane. During stirring at -20 to 30°C, nanocrystals 911 are precipitated, and 3-aminopropyltriethoxysilane and oleic acid are coordinated on the surfaces of the nanocrystals 911.

Then, the obtained reaction solution is stirred at room temperature (10 to 30°C, humidity 5 to 60%) for 5 to 300 minutes in the air, and then 0.1 to 50 mL of ethanol is added to obtain a suspension. The alkoxysilyl group of 3-aminopropyltriethoxysilane is condensed while stirring at room temperature in the air to form the surface layer 912 having a siloxane bond on the surface of the nanocrystal 911.

By centrifuging the obtained suspension to recover the solid matter and adding the solid matter to hexane, it is possible to obtain a parent particle dispersion liquid in which the parent particles 91 including the surface layer 912 having a siloxane bond on the surface of the nanocrystal 911 composed of lead cesium tribromide are dispersed in toluene.

Next, a method for producing the parent particles 91 without heating will be described. A method can be mentioned in which a solution containing a raw material compound for semiconductor nanocrystals and a solution containing a compound containing Si and having a reactive group capable of forming a siloxane bond were mixed in the air, and then the obtained mixture was added to a large amount of organic solvent which is a poor solvent for the nanocrystals, thereby precipitating nanocrystals. The amount of the organic solvent used is preferably 10 to 1000 times the amount of the semiconductor nanocrystals on a mass basis. Further, the precipitated nanocrystals have the surface layer 912 having a siloxane bond formed on the surfaces of the nanocrystals 911, and the nanocrystals can be obtained by a conventional method such as centrifugation.

Specifically, as a solution containing a raw material compound for semiconductor nanocrystals, for example, a solution containing lead (II) bromide, methylamine hydrobromide and an organic solvent is prepared. The organic solvent only needs to be a good solvent for nanocrystals, but dimethyl sulfoxide, N,N-dimethylformamide, N-methylformamide, and a mixed solvent thereof are preferable from the viewpoint of compatibility. At this time, it is preferable to adjust the addition amount of lead (II) bromide (II) having 50 to 200 mg and the addition amount of methylamine hydrobromide having 10 to 100 mg with respect to 10 mL of the organic solvent.

On the other hand, as a solution containing a compound containing Si and having a reactive group capable of forming a siloxane bond, for example, 3-aminopropyltriethoxysilane, oleic acid, and a poor solvent are prepared. As the poor solvent, isopropyl alcohol, toluene, hexane, and the like can be used. At this time, it is preferable that the amount of each addition is adjusted so that 3-aminopropyltriethoxysilane is 0.01 to 0.5 mL and oleic acid is 0.01 to 0.5 mL with respect to 5 mL of the poor solvent.

Then, with respect to 0.1 to 5 mL of the above-mentioned solution containing lead (II) bromide and methylamine hydrobromide, 5 mL of the above-mentioned solution containing 3-aminopropyltriethoxysilane is added at 0 to 60°C in the air to obtain a mixture. Immediately after that, the obtained mixture is added to a large amount of negative solvent, stirred in the air for 5 to 180 seconds, and then the solid matter is recovered by centrifugation. When the mixture is added to a large amount of negative solvent, the nanocrystals 911 are precipitated and 3-aminopropyltriethoxysilane and oleic acid are coordinated on the surfaces of the nanocrystals 911. Then, the alkoxysilyl group of 3-aminopropyltriethoxysilane is condensed while stirring in the air, and the surface layer 912 having a siloxane bond is formed on the surface of the nanocrystal 911.

By adding the recovered solid matter to toluene, it is possible to obtain a parent particle dispersion in which the parent particle 91 having the surface layer 912 having a siloxane bond on the surface of the nanocrystal 911 composed of methylammonium tribromide crystal is dispersed in toluene.

### <<Step 2 (Polymer Layer Forming Step)>>

Next, the surface of the parent particle 91 obtained in step 1 is coated with a hydrophobic polymer to form the polymer layer 92. The parent particle 91 is coated with the hydrophobic polymer layer 92. As a result, the light-emitting particle 90 can be provided with high stability against oxygen and moisture. Further, when the ink composition is prepared, the dispersion stability of the light-emitting particles 90 can be improved.

Such a polymer layer 92 can be formed by Method I: a method of coating the surface of the parent particle 91 with a hydrophobic polymer by adding and mixing the parent particle 91 to a varnish containing a hydrophobic polymer; Method II: a method of carrying at least one polymerizable unsaturated monomer that is soluble in a non-aqueous solvent and becomes insoluble or sparingly soluble after polymerization, together with a polymer having a polymerizable unsaturated group soluble in a non-aqueous solvent on the surface of the parent particle 91, and then polymerizing the polymer and the polymerizable unsaturated monomer; or the like.

Note that the hydrophobic polymer in Method I includes a polymer obtained by polymerizing the polymer and the polymerizable unsaturated monomer in Method II.

Among them, the polymer layer 92 is preferably formed by Method II. According to Method II, the polymer layer 92 having a uniform thickness can be formed on the parent particle 91 with high adhesion.

### [Non-Aqueous Solvent]

The non-aqueous solvent used in this step is preferably an organic solvent capable of dissolving the hydrophobic polymer, and more preferably one capable of uniformly dispersing the parent particles 91. By using such a non-aqueous solvent, the hydrophobic polymer can be adsorbed on the parent particles 91 and the polymer layer 92 can be coated very easily. Further, preferably, the non-aqueous solvent is a low dielectric constant solvent. By using a low dielectric constant solvent, the hydrophobic polymer can be strongly adsorbed on the surfaces of the parent particles 91 and the polymer layer 92 can be coated by simply mixing the hydrophobic polymer and the parent particles 91 in the non-aqueous solvent.

The polymer layer 92 thus obtained is difficult to be removed from the parent particles 91 even if the light-emitting particles 90 are washed with a solvent. Further, the lower the dielectric constant of the non-aqueous solvent, the more preferable. Specifically, the dielectric constant of the non-aqueous solvent is preferably 10 or less, more preferably 6 or less, and particularly preferably 5 or less. Preferred non-aqueous solvents are an aliphatic hydrocarbon solvent and an alicyclic hydrocarbon solvent, and an organic solvent containing at least one of the above is preferable.

Examples of the aliphatic hydrocarbon solvent or the alicyclic hydrocarbon solvent include n-hexane, n-heptane, n-octane, cyclopentane, cyclohexane, and the like.

Further, as long as the effect of the present invention is not impaired, a mixed solvent obtained by mixing at least one of an aliphatic hydrocarbon solvent and an alicyclic hydrocarbon solvent with another organic solvent may be used as the non-aqueous solvent. Examples of such other organic solvents include aromatic hydrocarbon solvents such as toluene and xylene; ester solvents such as methyl acetate, ethyl acetate, n-butyl acetate, and amyl acetate; ketone solvents such as acetone, methyl ethyl ketone, and methyl isobutyl ketone, methyl amyl ketones, and cyclohexanone; alcohol solvents such as methanol, ethanol, n-propanol, i-propanol, and n-butanol; and the like.

When used as a mixed solvent, the used amount of at least one of the aliphatic hydrocarbon solvent and the alicyclic hydrocarbon solvent is preferably 50% by mass or more, and more preferably 60% by mass or more.

### [Polymer Containing Polymerizable Unsaturated Group Soluble in Non-Aqueous Solvent]

The polymer containing a polymerizable unsaturated group soluble in a non-aqueous solvent used in this step (hereinafter, also referred to as "polymer (P)") includes a polymer in which a polymerizable unsaturated group is introduced into a copolymer of a polymerizable unsaturated monomer containing an alkyl (meth)acrylate (A) having an alkyl group having 4 or more carbon atoms, or a fluorine-containing compound (B, C) having a polymerizable unsaturated group as a main component, or a macromonomer composed of a copolymer of a polymerizable unsaturated monomer containing an alkyl (meth)acrylate (A) having an alkyl group having 4 or more carbon atoms, or a fluorine-containing compound (B, C) having a polymerizable unsaturated group as a main component, and the like.

Examples of the alkyl (meth)acrylate (A) include n-butyl (meth)acrylate, i-butyl (meth)acrylate, t-butyl (meth)acrylate, 2-ethylhexyl (meth)acrylate, isooctyl (meth)acrylate, isodecyl (meth)acrylate, lauryl (meth)acrylate, stearyl (meth)acrylate, isostearyl (meth)acrylate, cyclohexyl (meth)acrylate, isobornyl (meth)acrylate, dicyclopentenyl (meth)acrylate, dicyclopentanyl (meth)acrylate. Here, in the present specification, "(meth)acrylate" means both methacrylate and acrylate. The same applies to the expression "(meth)acryloyl".

On the other hand, examples of the fluorine-containing compound (B) having a polymerizable unsaturated group include a compound represented by the following general formula (B1).

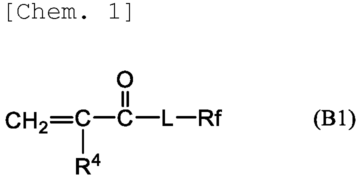

In the above general formula (B1), R⁴ is a hydrogen atom, a fluorine atom, a methyl group, a cyano group, a phenyl group, a benzyl group or -CₙH₂ₙ-Rf' (where n is an integer of 1 to 8 and Rf' is any one group of the following formulas (Rf-1) to (Rf-7)).

Further, in the above general formula (B1), L is any one group of the following formulas (L-1) to (L-10). 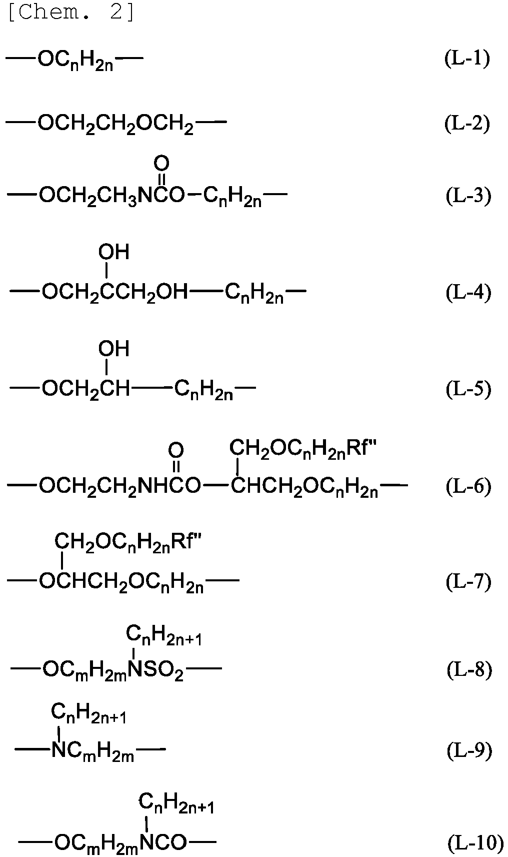 (n in the above formulas (L-1), (L-3), (L-5), (L-6), and (L-7) is an integer of 1 to 8. In the above formulas (L-8), (L-9), and (L-10), m is an integer of 1 to 8, and n is an integer of 0 to 8. Rf" in the above formulas (L-6) and (L-7) is any one group of the following formulas (Rf-1) to (Rf-7).)

Further, in the above general formula (B1), Rf is any one group of the following formulas (Rf-1) to (Rf-7). 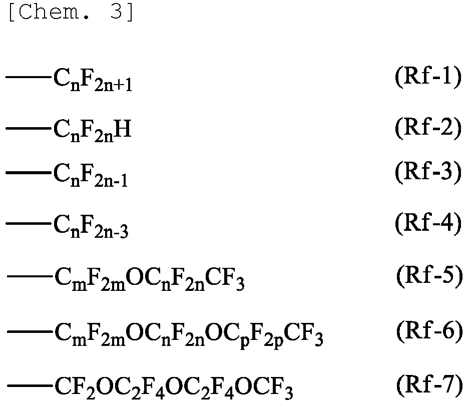 (n in the above formulas (Rf-1) to (Rf-4) is an integer of 4 to 6. In the above formula (Rf-5), m is an integer of 1 to 5, n is an integer of 0 to 4, and the sum of m and n is 4 to 5. In the above formula (Rf-6), m is an integer of 0 to 4, n is an integer of 1 to 4, p is an integer of 0 to 4, and the sum of m, n, and p is 4 to 5.)

Further, as preferable specific examples of the compound represented by the general formula (B1), methacrylates represented by the following formulas (B1-1) to (B1-7) and acrylates represented by the following (B1-8) to (B1-15), and the like can be mentioned. Note that these compounds may be used alone or in combination of two or more.

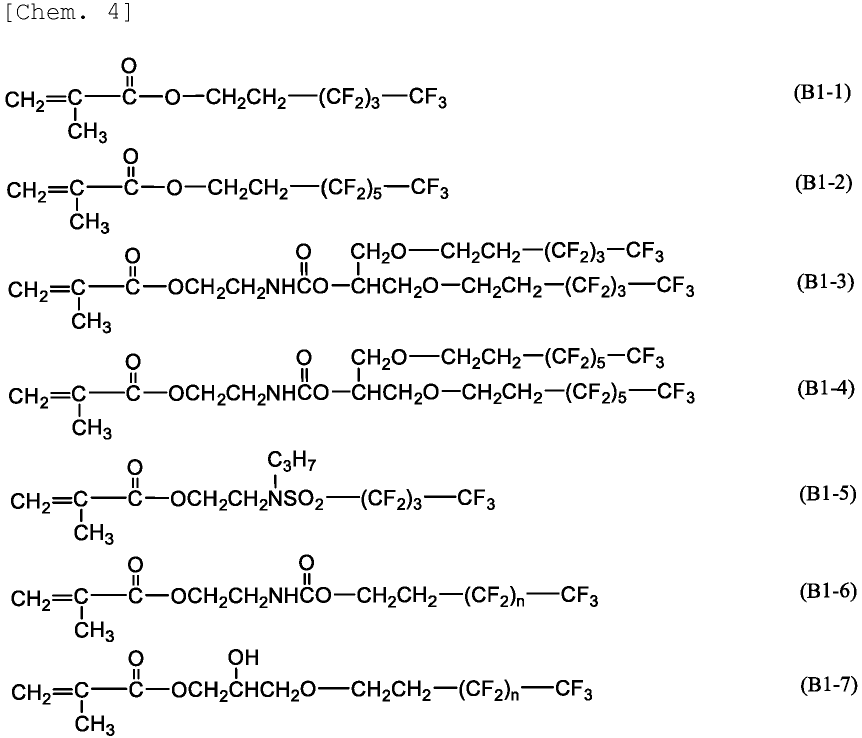

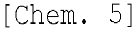

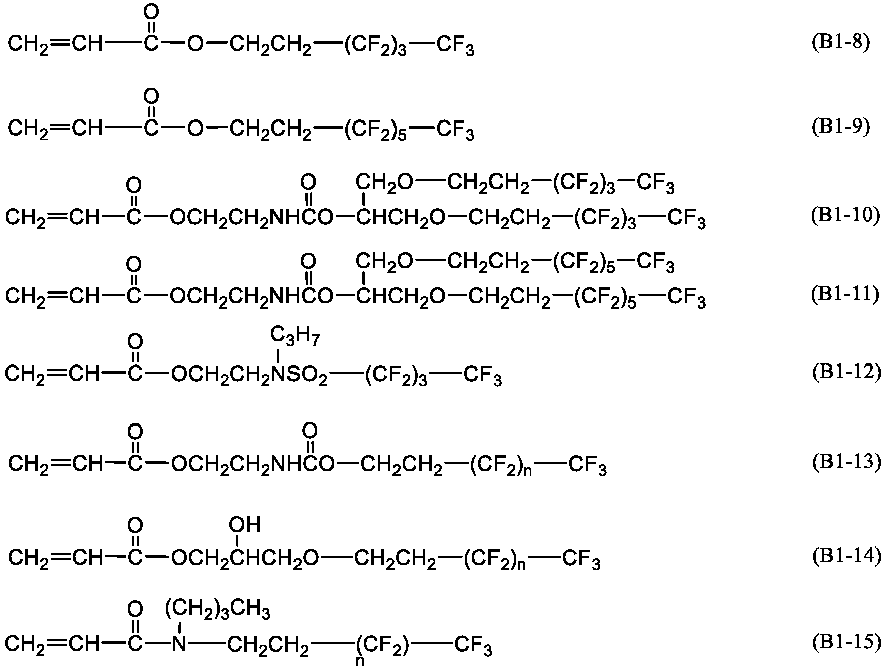

Examples of the fluorine-containing compound (C) having a polymerizable unsaturated group include a poly(perfluoroalkylene ether) chain and a compound having a polymerizable unsaturated group at both ends thereof.

The poly(perfluoroalkylene ether) chain preferably has a structure in which divalent fluorocarbon groups having 1 to 3 carbon atoms and oxygen atoms are alternately linked.

Such a poly(perfluoroalkylene ether) chain may contain only one type of divalent fluorocarbon group having 1 to 3 carbon atoms, or may contain a plurality of types. Specific examples of the poly(perfluoroalkylene ether) include a structure represented by the following general formula (C1).

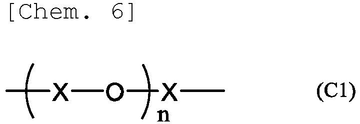

In the above general formula (C1), X is the following formulas (C1-1) to (C1-5).

A plurality of X may be the same or different. When different X are included (when a plurality of types of repeating units X-O are included), a plurality of the same repeating units X-O may exist in a random shape or in a block shape.

Also, n is the number of repeating units and is an integer of 1 or more.

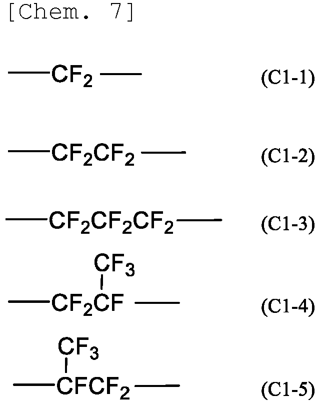

Among them, as the poly(perfluoroalkylene ether) chain, a structure in which perfluoromethylene represented by the above formula (C1-1) and perfluoroethylene represented by the above formula (C1-2) coexist is preferable in that the balance between the number of fluorine atoms and the number of oxygen atoms is good, and the polymer (P) is easily entangled with the surface of the parent particle 91.

In this case, the abundance ratio of perfluoromethylene represented by the above formula (C1-1) and perfluoroethylene represented by the above formula (C1-2) is preferably 1/10 to 10/1, more preferably 2/8 to 8/2, and even more preferably 3/7 to 7/3 in the molar ratio [perfluoromethylene (C1-1)/Perfluoroethylene (C1-2)].

Further, n in the above general formula (C1) is preferably 3 to 100, and more preferably 6 to 70. Further, the total number of fluorine atoms contained in the poly(perfluoroalkylene ether) chain is preferably 18 to 200, and more preferably 25 to 150. In the poly (perfluoroalkylene ether) chain having such a structure, the balance between the number of fluorine atoms and the number of oxygen atoms becomes even better.

Examples of the raw material compound having a poly(perfluoroalkylene ether) chain before introducing a polymerizable unsaturated group at both ends include the following formulas (C2-1) to (C2-6). Note that "-PFPE-" in the following formulas (C2-1) to (C2-6) is a poly(perfluoroalkylene ether) chain.

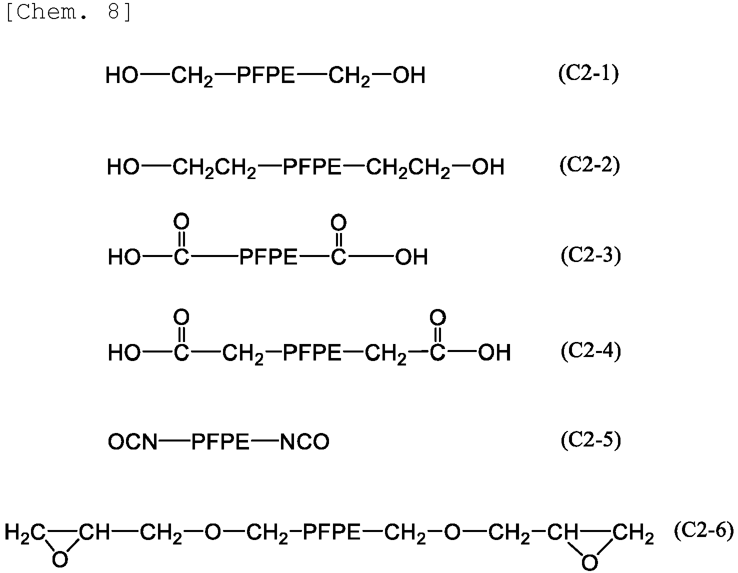

Examples of the polymerizable unsaturated group introduced at both ends of the poly(perfluoroalkylene ether) chain include structures represented by the following formulas U-1 to U-5.

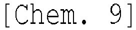

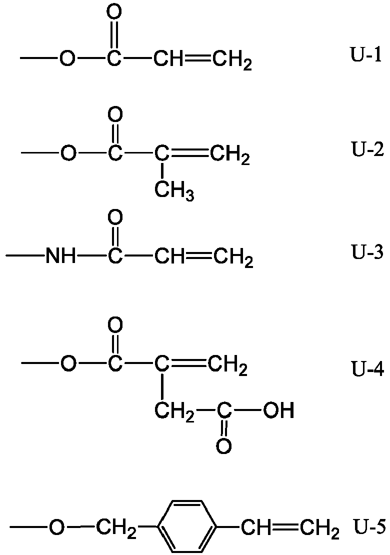

Among them, the acryloyloxy group represented by the above formula U-1 or the methacryloyloxy group represented by the above formula U-2 are preferable in terms of the ease of obtaining and producing the fluorine-containing compound (C) per se or the ease of copolymerization with other polymerizable unsaturated monomers.

Specific examples of the fluorine-containing compound (C) include compounds represented by the following formulas (C-1) to (C-13). Note that "-PFPE-" in the following formulas (C-1) to (C-13) is a poly(perfluoroalkylene ether) chain.

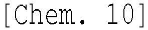

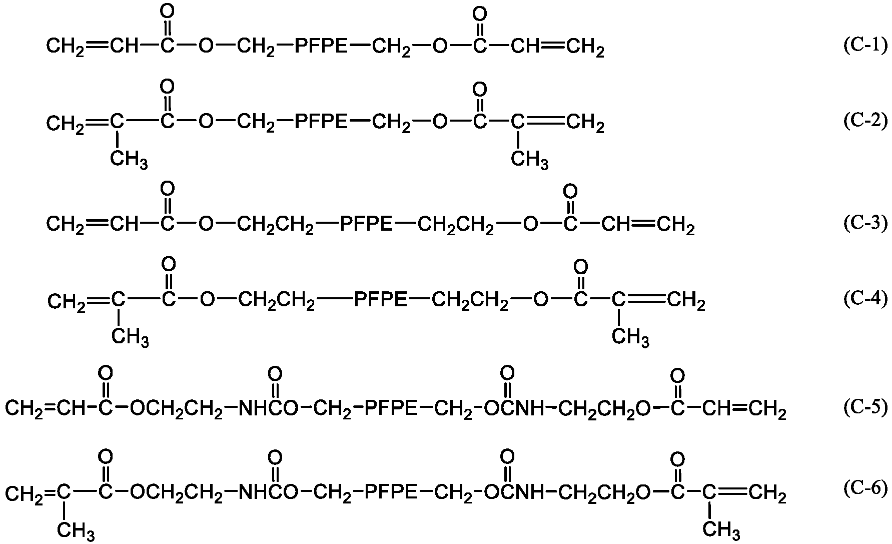

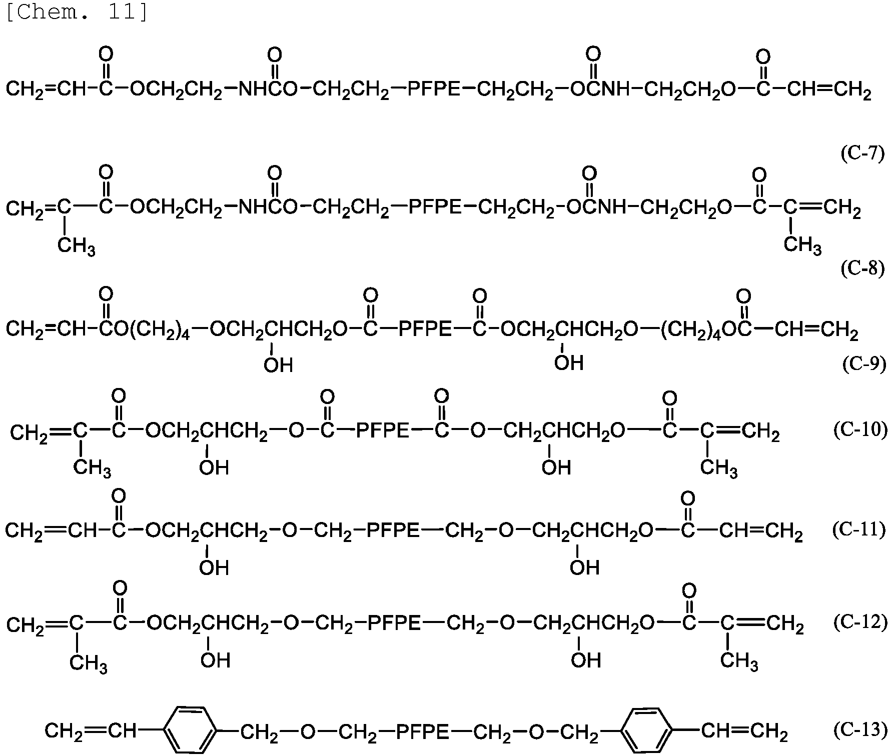

Among them, as the fluorine-containing compound (C), compounds represented by the above formulas (C-1), (C-2), (C-5), or (C-6) are preferable in terms of easy industrial production, and a compound having an acryloyl group at both ends of the poly(perfluoroalkylene ether) chain represented by the above formula (C-1), or a compound having a methacryloyl group at both ends of the poly(perfluoroalkylene ether) chain represented by the above formula (C-2) is more preferable in that the polymer (P) that is easily entangled with the surface of the parent particle 91 can be synthesized.

Further, examples of compounds other than the alkyl (meth)acrylate (A) and the fluorine-containing compounds (B, C) that can be used as the polymerizable unsaturated monomer include aromatic vinyl compounds such as styrene, α-methylstyrene, and p-t-butylstyrene, and vinyltoluene; (meth)acrylate compounds such as benzyl (meth)acrylate, dimethylamino (meth)acrylate, diethylamino (meth)acrylate, dibromopropyl (meth)acrylate, tribromophenyl (meth)acrylate; diester compounds of unsaturated dicarboxylic acids such as maleic acid, fumaric acid, and itaconic acid and monovalent alcohols, vinyl ester compounds such as vinyl benzoate, "Beova" (vinyl ester manufactured by Shell, Netherlands), and the like.

These compounds are preferably used as a random copolymer with an alkyl (meth)acrylate (A) or a fluorine-containing compound (B, C). Thereby, the solubility of the obtained polymer (P) in a non-aqueous solvent can be sufficiently enhanced.

As the compound that can be used as the above-mentioned polymerizable unsaturated monomer, one type may be used alone, or two or more types may be used in a combination. Among them, it is preferable to use alkyl (meth)acrylate (A) having a linear or branched alkyl group having 4 to 12 carbon atoms, such as n-butyl (meth)acrylate, 2-ethylhexyl (meth)acrylate, and lauryl methacrylate.

The copolymer of a polymerizable unsaturated monomer can be obtained by polymerizing a polymerizable unsaturated monomer by a conventional method.

Further, the polymer (P) can be obtained by introducing a polymerizable unsaturated group into such a copolymer.

Examples of the method for introducing the polymerizable unsaturated group include the following Methods I to IV.

The method I is a method in which a polymerizable monomer containing a carboxylic acid group such as acrylic acid and methacrylic acid, and an amino group-containing polymerizable monomer such as dimethylaminoethyl methacrylate and dimethylaminopropylacrylamide are in advance blended as copolymerization components and copolymerized to obtain a copolymer having a carboxylic acid group or an amino group, and then the carboxylic acid group or the amino group is reacted with a monomer having a glycidyl group and a polymerizable unsaturated group, such as glycidyl methacrylate.

Method II is a method in which a hydroxyl group-containing monomer such as 2-hydroxyethyl methacrylate or 2-hydroxyethyl acrylate is in advance blended as a copolymerization component and copolymerized to obtain a copolymer having a hydroxyl group, and then the hydroxyl group is reacted with a monomer having an isocyanate group and a polymerizable unsaturated group, such as isocyanate ethyl methacrylate.

Method III is a method in which thioglycolic acid is used as a chain transfer agent during polymerization to introduce a carboxyl group at the end of the copolymer, and the carboxyl group is reacted with a monomer having a glycidyl group and a polymerizable unsaturated group, such as glycidyl methacrylate.

Method IV is a method in which a carboxyl group-containing azo initiator such as azobiscyanopentanoic acid is used as a polymerization initiator to introduce a carboxyl group into the copolymer, and the carboxyl group is reacted with a monomer having a glycidyl group and a polymerizable unsaturated group, such as glycidyl methacrylate.

Among them, Method I is preferable since it is the simplest.

### (Polymerizable Unsaturated Monomer That Is Soluble in Non-Aqueous Solvent and Becomes Insoluble or Sparingly Soluble After Polymerization)

The polymerizable unsaturated monomers (hereinafter, also referred to as "monomer (M)") used in this step that is soluble in a non-aqueous solvent and becomes insoluble or sparingly soluble after polymerization include, for example, vinyl-based monomers having no reactive polar group (functional group), vinyl-based monomers containing amide bond, (meth)acryloyloxyalkyl phosphates, (meth)acryloyloxyalkyl phosphites, phosphorus atomcontaining vinyl-based monomers, hydroxyl group-containing polymerizable unsaturated monomers, dialkylaminoalkyl (meth)acrylates, epoxy group-containing polymerizable unsaturated monomers, isocyanate group-containing α,β-ethylenically unsaturated monomers, alkoxysilyl group-containing polymerizable unsaturated monomers, carboxyl group-containing α,β-ethylenically unsaturated monomers, and the like.

Specific examples of vinyl-based monomers having no reactive polar group include, for example, (meth)acrylates such as methyl (meth)acrylate, ethyl (meth)acrylate, n-propyl (meth)acrylate, and i-propyl (meth)acrylate, olefins such as (meth)acrylonitrile, vinyl acetate, vinyl chloride, vinylidene chloride, vinyl fluoride, and vinylidene fluoride, and the like.

Specific examples of the vinyl-based monomers containing an amide bond include, for example, (meth)acrylamide, dimethyl (meth)acrylamide, N-t-butyl (meth)acrylamide, N-octyl (meth)acrylamide, diacetone acrylamide, dimethylaminopropylacrylamide, alkoxylated N-methylolated (meth)acrylamides, and the like.

Specific examples of (meth)acryloyloxyalkyl phosphates include, for example, dialkyl[(meth)acryloyloxyalkyl] phosphates, (meth)acryloyloxyalkyl acid phosphates, and the like.

Specific examples of (meth)acryloyloxyalkyl phosphites include, for example, dialkyl[(meth)acryloyloxyalkyl] phosphites, (meth)acryloyloxyalkyl acid phosphites, and the like.

Specific examples of the vinyl-based monomers containing phosphorus atoms include, for example, alkylene oxide adducts of the above (meth)acryloyloxyalkyl acid phosphates or (meth)acryloyloxyalkyl acid phosphites, ester compounds of vinyl-based monomers containing an epoxy group such as glycidyl (meth)acrylates and methylglycidyl (meth)acrylate, and phosphoric acid and phosphorous acid, or acidic esters thereof, 3-chloro-2-acid phosphoxypropyl (meth)acrylate and the like.

Specific examples of hydroxyl group-containing polymerizable unsaturated monomers include, for example, hydroxyalkyl esters of polymerizable unsaturated carboxylic acids such as 2-hydroxyethyl (meth)acrylate, 2-hydroxypropyl (meth)acrylate, 3-hydroxypropyl (meth)acrylate, 2-hydroxybutyl (meth)acrylate, 3-hydroxybutyl (meth)acrylate, 4-hydroxybutyl (meth)acrylate, 3-chloro-2-hydroxypropyl (meth)acrylate, di-2-hydroxyethyl fumarate, mono-2-hydroxyethyl monobutyl fumarate, polypropylene glycol mono (meth)acrylate, polyethylene glycol mono (meth)acrylate, or adducts thereof with ε-caprolactone; polymerizable unsaturated carboxylic acids such as unsaturated mono- or dicarboxylic acids, such as (meth)acrylic acid, crotonic acid, maleic acid, fumaric acid, itaconic acid, and citraconic acid, and monoesters of dicarboxylic acid and monovalent alcohol; adducts of various unsaturated carboxylic acids such as adducts of hydroxyalkyl esters of the polymerizable unsaturated carboxylic acids with polycarboxylic acid anhydrides (maleic acid, succinic acid, phthalic acid, hexahydrophthalic acid, tetrahydrophthalic acid, henzentricarboxylic acid, benzenetetracarboxylic acid, "himic acid", tetrachlorophthalic acid, dodecynyl succinic acid, and the like), with monoepoxy compounds, such as monoglycidyl esters of monovalent carboxylic acid (palm oil fatty acid glycidyl ester, octyl acid glycidyl ester, etc.), butyl glycidyl ether, ethylene oxide, propylene oxide, and the like, or adducts thereof with ε-caprolactone; hydroxyvinyl ethers, and the like.

Specific examples of dialkylaminoalkyl (meth)acrylates include, for example, dimethylaminoethyl (meth)acrylate, diethylaminoethyl (meth)acrylate, and the like.

Specific examples of epoxy group-containing polymerizable unsaturated monomers include, for example, epoxy group-containing polymerizable compounds obtained by adding various polyepoxy compounds having at least two epoxy groups in one molecule to various unsaturated carboxylic acids such as polymerizable unsaturated carboxylic acids and equimolar adducts of a hydroxyl group-containing vinyl monomer and a polycarboxylic acid anhydride (mono-2-(meth)acryloyloxymonoethyl phthalate, and the like) at an equimolar ratio, glycidyl (meth)acrylate, (β-methyl) glucidyl (meth)acrylate, (meth)allyl glucidyl ether, and the like.

Specific examples of the isocyanate group-containing α,β-ethylenically unsaturated monomers include, for example, equimolar adducts of 2-hydroxyethyl (meth)acrylate and hexamethylene diisocyanate, and monomers having an isocyanate group and a vinyl group, such as isocyanate ethyl (meth)acrylate.

Specific examples of the alkoxysilyl group-containing polymerizable unsaturated monomers include, for example, silicon-based monomers such as vinylethoxysilane, α-methacryloxypropyltrimethoxysilane, and trimethylsiloxyethyl (meth)acrylate.

Specific examples of the carboxyl group-containing α,β-ethylenically unsaturated monomers include, for example, α,β-ethylenically unsaturated carboxylic acids such as unsaturated mono- or dicarboxylic acids such as (meth)acrylic acid, crotonic acid, maleic acid, fumaric acid, itaconic acid, and citraconic acid, and monoesters of dicarboxylic acids and monovalent alcohols; adducts of the hydroalkyl esters of α,β-ethylenically unsaturated carboxylic acids such as 2-hydroxyethyl (meth)acrylate, 2-hydroxypropyl (meth)acrylate, 3-hydroxypropyl (meth)acrylate, 2-hydroxybutyl (meth)acrylate, 3-hydroxybutyl (meth)acrylate, 4-hydroxybutyl (meth)acrylate, 3-chloro-2-hydroxypropyl (meth)acrylate, di-2-hydroxyethyl fumarate, mono-2-hydroxyethyl-monobutyl fumarate, and polyethylene glycol mono (meth)acrylate, with anhydrides of polycarboxylic acids such as maleic acid, succinic acid, phthalic acid, hexahydrophthalic acid, tetrahydrophthalic acid, benzenetricarboxylic acid, benzenetetracarboxylic acid, "himic acid", tetrachlorphthalic acid, and dodecynylsuccinic acid.

Among them, as the monomer (M), an alkyl (meth)acrylate having an alkyl group having 3 or less carbon atoms, such as methyl (meth)acrylate and ethyl (meth)acrylate is preferable.

Further, when the polymer (P) and the monomer (M) are polymerized, it is preferable to copolymerize the polymerizable unsaturated monomer having at least one of functional groups such as a carboxyl group, a sulfonic acid group, a phosphoric acid group, a hydroxyl group, and a dimethylamino group. As a result, the adhesion of the formed polymer (polymer layer 92) to the surface of the parent particle 91 can be improved by enhancing the interaction with the siloxane bond.

Further, in order to prevent or suppress the elution of the hydrophobic polymer from the obtained light-emitting particles 90, the hydrophobic polymer (polymer (P)) is preferably crosslinked.

Examples of the polyfunctional polymerizable unsaturated monomer that can be used as a cross-linking component include, for example, divinylbenzene, ethylene glycol di(meth)acrylate, diethylene glycol di(meth)acrylate, triethylene glycol di(meth)acrylate, polyethylene glycol di(meth)acrylate, 1,3-butanediol di(meth)acrylate, 1,4-butanediol di(meth)acrylate, 1,6-hexanediol di(meth)acrylate, neopentyl glycol dimethacrylate, trimethylolpropan triethoxy tri(meth)acrylate, trimethylolpropan tri(meth)acrylate, pentaerythritol tri(meth)acrylate, pentaerythritol tetra(meth)acrylate, dipentaerythritol hexa(meth)acrylate, and allyl methacrylate.

Further, other polymerizable unsaturated monomers may be copolymerized as long as the obtained hydrophobic polymer is not dissolved in a non-aqueous solvent. Other polymerizable unsaturated monomers include, for example, the above-mentioned alkyl (meth)acrylate (A), fluorine-containing compounds (B, C), and compounds exemplified as polymerizable unsaturated monomers for polymers (P) that can be used in addition to the above.

The polymer layer 92 is formed by polymerizing the monomer (M) in the presence of the parent particles 91, a non-aqueous solvent, and the polymer (P).

Preferably, the parent particles 91 and the polymer (P) are mixed before the polymerization is carried out. For mixing, for example, a homogenizer, a disper, a bead mill, a paint shaker, a kneader, a roll mill, a ball mill, an attritor, a sand mill, and the like can be used.

In the present invention, the form of the parent particle 91 used is not particularly limited and may be any of slurry, wet cake, powder, and the like.

After mixing the parent particle 91 and the polymer (P), the monomer (M), and the polymerization initiator described later are further mixed and polymerized to form a polymer layer 92 composed of the polymer (P) and the monomer (M). As a result, the light-emitting particles 90 are obtained.

At this time, the number average molecular weight of the polymer (P) is preferably 1,000 to 500,000, more preferably 2,000 to 200,000, and even more preferably 3,000 to 100,000. By using the polymer (P) having the molecular weight in such a range, the surfaces of the parent particles 91 can be satisfactorily coated with the polymer layer 92.

The amount of the polymer (P) used is appropriately set according to the purpose and is not particularly limited, but in general, is preferably 0.5 to 50 parts by mass, more preferably 1 to 40 parts by mass, and even more preferably 2 to 35 parts by mass with respect to 100 parts by mass of the parent particle 91.

Further, the amount of the monomer (M) used is also appropriately set according to the purpose and is not particularly limited, but in general, is preferably 0.5 to 40 parts by mass, more preferably 1 to 35 parts by mass, and even more preferably 2 to 30 parts by mass with respect to 100 parts by mass of the parent particle 91.

The amount of the hydrophobic polymer finally covering the surface of the parent particle 91 is preferably 1 to 60 parts by mass, more preferably 2 to 50 parts by mass, and even more preferably 3 to 40 parts by mass with respect to 100 parts by mass of the parent particle 91.

In this case, the amount of the monomer (M) is usually preferably 10 to 100 parts by mass, more preferably 30 to 90 parts by mass, even more preferably 50 to 80 parts by mass with respect to 100 parts by mass of the polymer (P).

The thickness of the polymer layer 92 is preferably 0.5 to 100 nm, more preferably 0.7 to 50 nm, and even more preferably 1 to 30 nm. If the thickness of the polymer layer 92 is less than 0.5 nm, dispersion stability is not likely to be obtained. If the thickness of the polymer layer 92 exceeds 100 nm, it is often difficult to contain the parent particles 91 at a high concentration. By coating the parent particles 91 with the polymer layer 92 having such a thickness, the stability of the light-emitting particles 90 with respect to oxygen and moisture can be further improved.

The polymerization of the monomer (M) in the presence of the parent particles 91, the non-aqueous solvent, and the polymer (P) can be carried out by a known polymerization method, but is preferably carried out in the presence of a polymerization initiator.

Such polymerization initiators include, for example, dimethyl-2,2-azobis(2-methylpropionate), azobisisobutyronitrile (AIBN), 2,2-azobis(2-methylbutyronitrile), benzoyl peroxide, t-butyl perbenzoate, t-butyl-2-ethylhexanoate, t-butyl hydroperoxide, di-t-butyl peroxide, cumene hydroperoxide, and the like. These polymerization initiators may be used alone or in combination of two or more.

The polymerization initiator, which is sparingly soluble in a non-aqueous solvent, is preferably added to a mixed solution containing the parent particles 91 and the polymer (P) in a state of being dissolved in the monomer (M).

Further, the monomer (M) or the monomer (M) in which the polymerization initiator is dissolved may be added to the mixed solution having reached the polymerization temperature by a dropping method to polymerize, but it is stable and preferable to be added to the mixed solution and mixed sufficiently at room temperature before the temperature rise, and then the temperature is raised to polymerize it.

The polymerization temperature is preferably in the range of 60 to 130°C, and more preferably in the range of 70 to 100°C. When the monomer (M) is polymerized at such a polymerization temperature, morphological changes (for example, alteration, crystal growth, and the like) of the nanocrystals 911 can be suitably prevented.

After the polymerization of the monomer (M), the polymer that has not been adsorbed on the surfaces of the parent particles 91 is removed to obtain light-emitting particles 90. Examples of the method for removing the unadsorbed polymer include centrifugal sedimentation and ultrafiltration. In the centrifugal sedimentation, the dispersion solution containing the parent particles 91 and the unadsorbed polymer is rotated at high speed to settle the parent particles 91 in the dispersion liquid, and the unadsorbed polymer is separated. In ultrafiltration, the dispersion solution containing the parent particles 91 and the unadsorbed polymer is diluted with an appropriate solvent, and the diluted solution is passed through a filtration membrane having an appropriate pore size to separate the unadsorbed polymer and the parent particles 91.

As described above, the light-emitting particles 90 can be obtained. The light-emitting particles 90 may be stored in a state of being dispersed in a dispersion medium or a photopolymerizable compound (that is, as a dispersion solution), or the dispersion medium may be removed and stored as powder (aggregate of light-emitting particles 90 alone).

### <Light-Emitting Particle Dispersion>

The light-emitting particle dispersion of the present invention contains light-emitting particles 90 and a dispersion medium for dispersing the light-emitting particles 90. Note that in the light-emitting particle dispersion of the present invention, it is possible to have a configuration containing light-emitting particles and a dispersion medium for dispersing the light-emitting particles, using the above-mentioned parent particles 91 as light-emitting particles.

### <<Dispersion Medium>>

As the dispersion medium, for example, aromatic solvents such as toluene, xylene, and methoxybenzene; acetic acid ester solvents such as ethyl acetate, propyl acetate, butyl acetate, propylene glycol monomethyl ether acetate, and propylene glycol monoethyl ether acetate; propionate solvents such as ethoxyethyl propionate; alcohol solvents such as methanol and ethanol; ether solvents such as butyl cellosolve, propylene glycol monomethyl ether, diethylene glycol ethyl ether, and diethylene glycol dimethyl ether; ketone solvents such as methyl ethyl ketone, methyl isobutyl ketone, and cyclohexanone; aliphatic hydrocarbon solvents such as hexane; nitrogen compound solvents such as N,N-dimethylformamide, γ-butyrolactam, N-methyl-2-pyrrolidone, aniline, and pyridine; lactone solvents such as γ-butyrolactone; carbamate esters such as a mixture of methyl carbamate and ethyl carbamate at a ratio of 48:52, water, and the like can be mentioned.

Among them, as the dispersion medium, a non-polar or low-polarity solvent such as an aromatic solvent, an acetate ester solvent, a ketone solvent, or an aliphatic hydrocarbon solvent is preferable and an aromatic solvent or an aliphatic hydrocarbon solvent is more preferable from the viewpoint of maintaining the light-emitting properties of the light-emitting particles. When these solvents are used, two or more types can be used in a combination.

### <Ink Composition>

The ink composition of the present invention contains the light-emitting particles 90, a photopolymerizable compound that disperses the light-emitting particles 90, and a photopolymerization initiator. Note that in the ink composition of the present invention, it is possible to have a configuration containing the light-emitting particles, a photopolymerizable compound that disperses the light-emitting particles, and a photopolymerization initiator, being the above-mentioned parent particles 91 as light-emitting particles.

The amount of the light-emitting particles 90 contained in the ink composition is preferably 10 to 50% by mass, more preferably 15 to 45% by mass, and even more preferably 20 to 40% by mass. By setting the amount of the light-emitting particles 90 contained in the ink composition in the above range, the ejection stability of the ink composition can be further improved when the ink composition is ejected by the inkjet printing method. In addition, the light-emitting particles 90 are less likely to agglomerate with each other, and the external quantum efficiency of the obtained light-emitting layer (light conversion layer) can be increased.

### <<Photopolymerizable Compound>>

The photopolymerizable compound contained in the ink composition of the present invention is preferably a photoradical polymerizable compound that polymerizes by irradiation with light and may be a photopolymerizable monomer or oligomer. These are used with photopolymerization initiators. One type of photopolymerizable compound may be used alone or two or more types may be used in a combination.

Examples of the photoradical polymerizable compound include (meth)acrylate compounds. The (meth)acrylate compound may be a monofunctional (meth)acrylate having one (meth)acryloyl group or may be a polyfunctional (meth)acrylate having a plurality of (meth)acryloyl groups.

Preferably, monofunctional (meth)acrylate and polyfunctional (meth)acrylate are used in a combination from the viewpoint of excellent fluidity when preparing an ink composition, excellent ejection stability, and suppressing deterioration of smoothness due to curing shrinkage during production of a light-emitting particle coating film.

The monofunctional (meth)acrylate includes, for example, methyl (meth)acrylate, ethyl (meth)acrylate, propyl (meth)acrylate, butyl (meth)acrylate, amyl (meth)acrylate, 2-ethylhexyl (meth)acrylate, octyl (meth)acrylate, nonyl (meth)acrylate, dodecyl (meth)acrylate, hexadecyl (meth)acrylate, octadecyl (meth)acrylate, cyclohexyl (meth)acrylate, methoxyethyl (meth)acrylate, butoxyethyl (meth)acrylate, phenoxyethyl (meth)acrylate, nonylphenoxyethyl (meth)acrylate, glycidyl (meth)acrylate, dimethylaminoethyl (meth)acrylate, diethylaminoethyl (meth)acrylate, isobornyl (meth)acrylate, dicyclopentanyl (meth)acrylate, dicyclopentenyl (meth)acrylate, dicyclopentenyloxyethyl (meth)acrylate, 2-hydroxy-3-phenoxypropyl (meth)acrylate, tetrahydrofurfuryl (meth)acrylate, 2-hydroxyethyl (meth)acrylate, benzyl (meth)acrylate, phenylbenzyl (meth)acrylate, mono(2-acryloyloxyethyl) succinate, N-[2-(acryloyloxy)ethyl] phthalimide, N-[2-(acryloyloxy)ethyl] tetrahydrophthalimide, and the like.

The polyfunctional (meth)acrylate may be a bifunctional (meth)acrylate, a trifunctional (meth)acrylate, a tetrafunctional (meth)acrylate, a pentafunctional (meth)acrylate, a hexafunctional (meth)acrylate, or the like, and may be, for example, di(meth)acrylate in which two hydroxyl groups of a diol compound are substituted with (meth)acryloyloxy group, di- or tri(meth)acrylate in which two or three hydroxyl groups of a triol compound are substituted with (meth)acryloyloxy group, and the like.

Specific examples of the bifunctional (meth)acrylate include, for example, 1,3-butylene glycol di(meth)acrylate, 1,4-butanediol di(meth)acrylate, 1,5-pentanediol di(meth)acrylate, 3-methyl-1,5-pentanediol di(meth)acrylate, 1,6-hexanediol di(meth)acrylate, neopentyl glycol di(meth)acrylate, 1,8-octanediol di(meth)acrylate, 1,9-nonandiol di(meth)acrylate, tricyclodecanedimethanol di(meth)acrylate, ethylene glycol di(meth)acrylate, polyethylene glycol di(meth)acrylate, propylene glycol di(meth)acrylate, dipropylene glycol di(meth)acrylate, tripropylene glycol di(meth)acrylate, polypropylene glycol di(meth)acrylate, neopentylglycol hydroxypivalic acid ester diacrylate, and di(meth)acrylate in which two hydroxyl groups of tris(2-hydroxyethyl) isocyanurate are substituted with (meth)acryloyloxy group, di(meth)acrylate in which two hydroxyl groups of the diol obtained by adding 4 mol or more of ethylene oxide or propylene oxide to 1 mol of neopentyl glycol are substituted with (meth)acryloyloxy group, di(meth)acrylate in which two hydroxyl groups of the diol obtained by adding 2 mol of ethylene oxide or propylene oxide to 1 mol of bisphenol A are substituted with (meth)acryloyloxy group, di(meth)acrylate in which two hydroxyl groups of the triol obtained by adding 3 mol or more of ethylene oxide or propylene oxide to 1 mol of trimethylolpropane are substituted with (meth)acryloyloxy group, di(meth)acrylate in which two hydroxyl groups of the diol obtained by adding 4 mol or more of ethylene oxide or propylene oxide to 1 mol of bisphenol A are substituted with (meth)acryloyloxy group, and the like.

Specific examples of the trifunctional (meth)acrylate include, for example, trimethylolpropane tri(meth)acrylate, glycerin triacrylate, pentaerythritol tri(meth)acrylate, tri(meth)acrylate in which the three hydroxyl groups of the triol obtained by adding 3 mol or more of ethylene oxide or propylene oxide to 1 mol of trimethylolpropane are substituted with (meth)acryloyloxy group, and the like.

Specific examples of the tetrafunctional (meth)acrylate include pentaerythritol tetra(meth)acrylate and the like.

Specific examples of the pentafunctional (meth)acrylate include dipentaerythritol penta(meth)acrylate.

Specific examples of the hexafunctional (meth)acrylate include dipentaerythritol hexa(meth)acrylate.

The polyfunctional (meth)acrylate may be a poly (meth)acrylate in which a plurality of hydroxyl groups of dipentaerythritol such as dipentaerythritol hexa(meth)acrylate are substituted with (meth)acryloyloxy group.

The (meth)acrylate compound may be an ethylene oxide-modified phosphoric acid (meth)acrylate, an ethylene oxide-modified alkyl phosphoric acid (meth)acrylate, or the like, which has a phosphoric acid group.

In the ink composition of the present invention, when the curable component is composed of a photopolymerizable compound only or as a main component, it is more preferable to use, as the photopolymerizable compound as described above, a bifunctional or higher polyfunctional photopolymerizable compound having two or more polymerizable functional groups in one molecule as an essential component since the durability (strength, heat resistance, and the like) of the cured product can be further enhanced.

The amount of the photopolymerizable compound contained in the ink composition is preferably 40 to 80% by mass, more preferably 45 to 75% by mass, and even more preferably 50 to 70% by mass. By setting the amount of the photopolymerizable compound contained in the ink composition in the above range, the dispersed state of the light-emitting particles 90 in the obtained light-emitting layer (light conversion layer) becomes good, and thus the external quantum efficiency can be further improved.

### <<Photopolymerization Initiator>>

The photopolymerization initiator in the ink composition used in the present invention is preferably at least one selected from the group consisting of alkylphenone-based compounds, acylphosphine oxide-based compounds, and oxime ester-based compounds.

Examples of the alkylphenone-based photopolymerization initiator include compounds represented by the formula (b-1) . 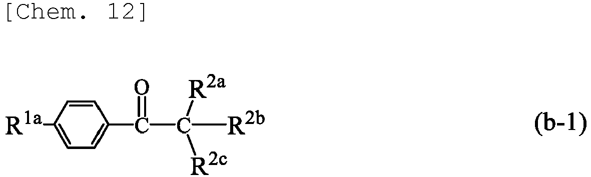 (In the formula, R1a represents a group selected from the following formulas (R^{1a}-1) to (R^{1a}-6), and R^{2a}, R^{2b}, and R^{2c} independently represent a group selected from the following formulas (R²-1) to (R²-7).)

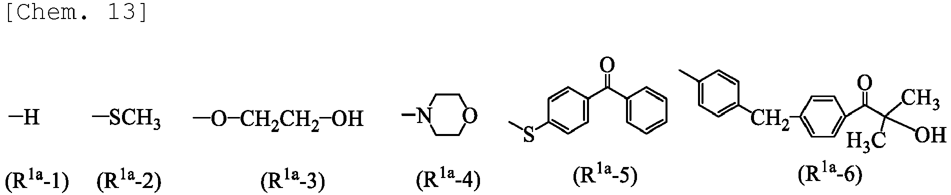

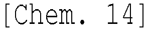

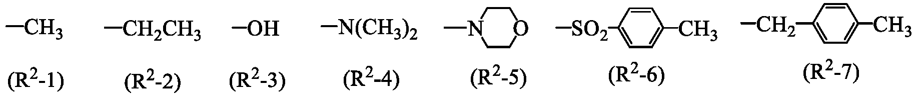

As a specific example of the compound represented by the above formula (b-1), the compounds represented by the following formulas (b-1-1) to (b-1-6) are preferable, and the compounds represented by the following formulas (b-1-1), (b-1-5), or (b-1-6) are more preferable.

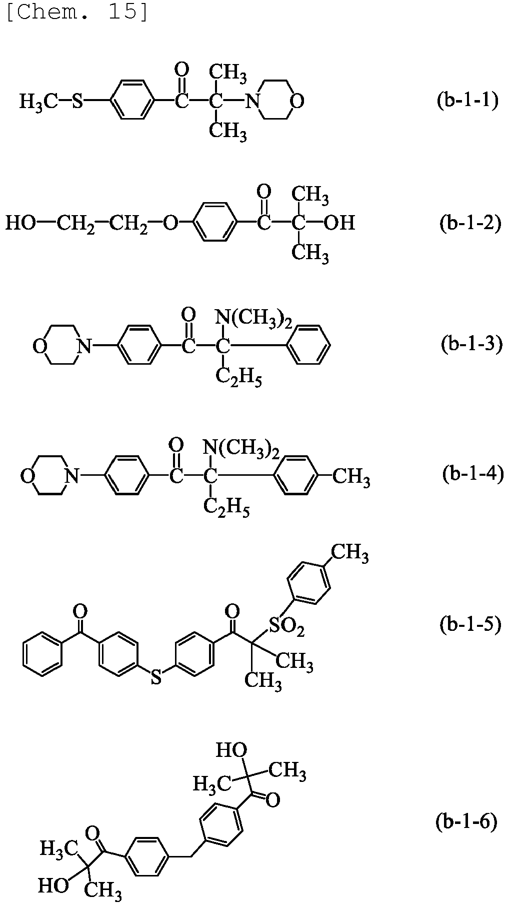

Examples of the acylphosphine oxide-based photopolymerization initiator include the compounds represented by the formula (b-2). 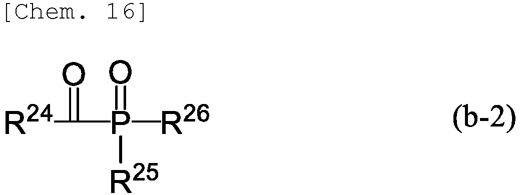 (In the formula, R²⁴ represents an alkyl group, an aryl group, or a heterocyclic group, and R²⁵ and R²⁶ independently represent an alkyl group, an aryl group, a heterocyclic group, or an alkanoyl group, where these groups may be substituted with an alkyl group, a hydroxyl group, a carboxyl group, a sulfone group, an aryl group, an alkoxy group or an arylthio group.)

As a specific example of the compound represented by the above formula (b-2), the compounds represented by the following formulas (b-2-1) to (b-2-5) are preferable, and the compounds represented by the following formula (b-2-1) or the formula (b-2-5) are more preferable.

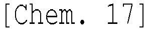

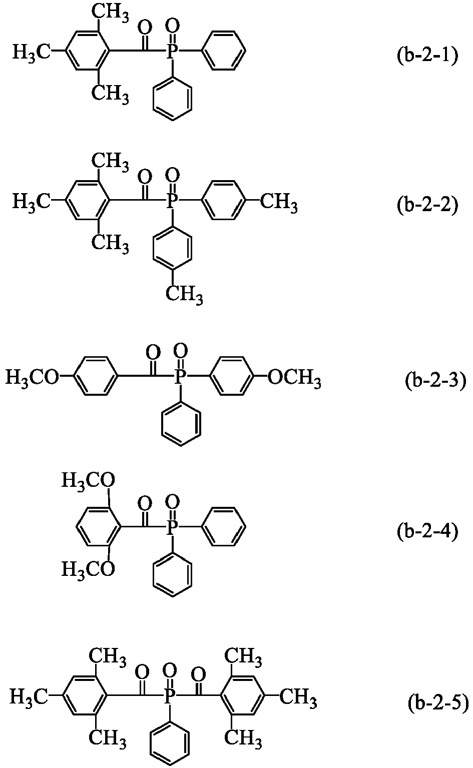

Examples of the oxime ester-based photopolymerization initiator include the compounds represented by the following formula (b-3-1) or formula (b-3-2). 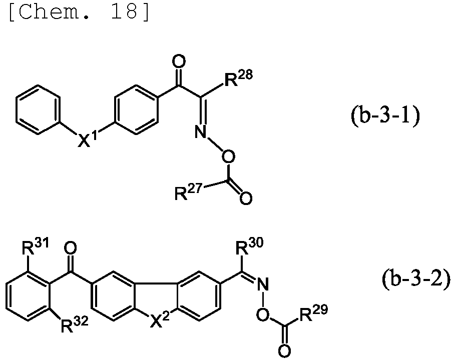 (In the formula, R²⁷ to R³¹ independently represent a hydrogen atom, a cyclic, linear, or branched alkyl group having 1 to 12 carbon atoms, or a phenyl group, where each alkyl group and phenyl group may be substituted with a substituent selected from the group consisting of a halogen atom, an alkoxyl group having 1 to 6 carbon atoms, and a phenyl group, where X¹ represents an oxygen atom or a nitrogen atom, X² represents an oxygen atom or an NR, and R represents an alkyl group having 1 to 6 carbon atoms.)

As specific examples of the compounds represented by the above formulas (b-3-1) and (b-3-2), the compounds represented by the following formulas (b-3-1-1) to (b-3-1-2) and the following formulas (b-3-2-1) to (b-3--2-2) are preferable, and the compounds represented by the following formulas (b-3-1-1), (b-3-2-1), or (b-3-2-2) are more preferable.

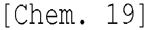

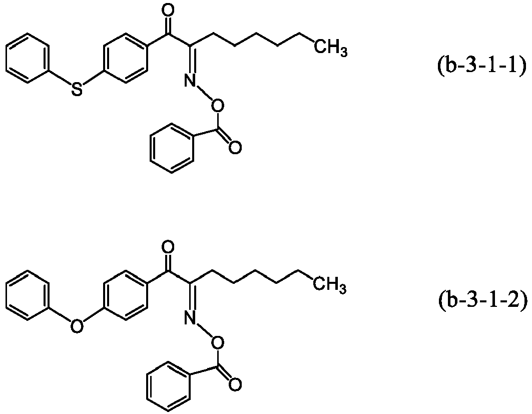

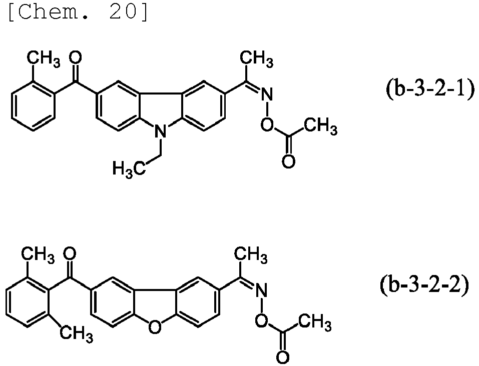

The blending amount of the photopolymerization initiator is preferably 0.05 to 10% by mass, more preferably 0.1 to 8% by mass, and even more preferably 1 to 6% by mass, based on the total amount of the photopolymerizable compounds contained in the ink composition. Note that the photopolymerization initiator can be used alone or in combination of two or more. An ink composition containing a photopolymerization initiator in such an amount maintains sufficient photosensitivity during photocuring, and crystals of the photopolymerization initiator are less likely to precipitate when the coating film is dried, and thus, the deterioration of the physical properties of the coating film can be suppressed.

When dissolving the photopolymerization initiator in the ink composition, it is preferable to dissolve the photopolymerization initiator in the photopolymerizable compound in advance before use.

In order to dissolve in the photopolymerizable compound, it is preferable to uniformly dissolve the photopolymerization initiator by adding the photopolymerization initiator while stirring the photopolymerizable compound so that the reaction due to heat is not started.

The dissolution temperature of the photopolymerization initiator may be appropriately adjusted in consideration of the solubility of the photopolymerization initiator used in the photopolymerizable compound and the thermal polymerizable property of the photopolymerizable compound, but the temperature is preferably 10 to 50°C, more preferably 10 to 40°C, and even more preferably 10 to 30°C from the viewpoint of not starting the polymerization of the photopolymerizable compound.

The ink composition used in the present invention may contain other components other than the light-emitting particles 90, the photopolymerizable compound, and the photopolymerization initiator as long as the effects of the present invention are not impaired. Examples of such other components include polymerization inhibitors, antioxidants, dispersants, leveling agents, chain transfer agents, dispersion aids, thermoplastic resins, sensitizers, light scattering particles, and the like.

### <<Polymerization Inhibitor>>

The polymerization inhibitors include, for example, phenolic compounds such as p-methoxyphenol, cresol, t-butylcatechol, 3,5-di-t-butyl-4-hydroxytoluene, 2,2'-methylene bis(4-methyl-6-t-butylphenol), 2,2'-methylene bis(4-ethyl-6-t-butylphenol), 4,4'-thiobis(3-methyl-6-t-butylphenol), 4-methoxy-1-naphthol, and 4,4'-dialkoxy-2,2'-bi-1-naphthol; quinone compounds such as hydroquinone, methylhydroquinone, tert-butylhydroquinone, p-benzoquinone, methyl-p-benzoquinone, tert-butyl-p-benzoquinone, 2,5-diphenylbenzoquinone, 2-hydroxy-1,4-naphthoquinone, 1,4-naphthoquinone, 2,3-dichloro-1,4-naphthoquinone, anthraquinone, and diphenoquinone; amine-based compounds such as p-phenylenediamine, 4-aminodiphenylamine, N,N'-diphenyl-p-phenylenediamine, N-i-propyl-N'-phenyl-p-phenylenediamine, N-(1.3-dimethylbutyl)-N'-phenyl-p-phenylenediamine, N,N'-di-2-naphthyl-p-phenylenediamine, diphenylamine, N-phenyl-β-naphthylamine, 4,4'-dicumyl-diphenylamine, and 4,4'-dioctyl-diphenylamine; thioether-based compounds such as phenothiazine, and distearylthiodipropionate; N-oxyl compounds such as 2,2,6,6-tetramethylpiperidine-1-oxyl free radical, 2,2,6,6-tetramethylpiperidine, 4-hydroxy-2,2,6,6-tetramethylpiperidin-1-oxyl free radical; nitroso compounds such as N-nitrosodiphenylamine, N-nitrosophenylnaphthylamine, N-nitrosodinaphthylamine, p-nitrosophenol, nitrosobenzene, p-nitrosodiphenylamine, α-nitroso-β-naphthol, N,N-dimethyl-p-nitrosoaniline, p-nitrosodiphenylamine, p-nitrosodimethylamine, p-nitroso-N,N-diethylamine, N-nitrosoethanolamine, N-nitroso-di-n-butylamine, N-nitroso-N-n-butyl-4-butanolamine, N-nitroso-diisopropanolamine, N-nitroso-N-ethyl-4-butanolamine, 5-nitroso-8-hydroxyquinoline, N-nitrosomorpholin, N-nitroso-N-phenylhydroxylamine ammonium salt (manufactured by Fuji Film Wako Pure Chemical Industries, Ltd., "Q-1300"), nitroso benzene, 2,4,6-tri-tert-butylnitronbenzene, N-nitroso-N-methyl-p-toluenesulfonamide, N-nitroso-N-ethylurethane, N-nitroso-N-n-propylurethane, 1-nitroso-2-naphthol, 2-nitroso-1-naphthol, sodium 1-nitroso-2-naphthol-3,6-sulfonate, sodium 2-nitroso-1-naphthol-4-sulfonate, 2-nitroso-5-methylaminophenol hydrochloride, 2-nitroso-5-methylaminophenol hydrochloride, Q-1301 (manufactured by Fuji Film Wako Pure Chemical Industries, Ltd.), and the like.

The amount of the polymerization inhibitor added is preferably 0.01 to 1.0% by mass, and more preferably 0.02 to 0.5% by mass, based on the total amount of the photopolymerizable compounds contained in the ink composition.

### <<Antioxidant>>

The antioxidant includes, for example, pentaerythritol tetrakis[3-(3,5-di-tert-butyl-4-hydroxyphenyl)propionate ("IRGANOX1010"), thiodiethylenebis[3-(3,5-di-tert-butyl-4-hydroxyphenyl) propionate ("IRGANOX1035"), octadecyl-3-(3,5-di-tert-butyl-4-hydroxyphenyl) propionate ("IRGANOX1076"), "IRGANOX1135", "IRGANOX1330", 4,6-bis(octylthiomethyl)-o-cresol ("IRGANOX1520L"), "IRGANOX1726", "IRGANOX245", "IRGANOX259", "IRGANOX3114", "IRGANOX3790", "IRGANOX5057", "IRGANOX565", (all above manufactured by BASF Co., Ltd.); "ADEKA STAB AO-20", "ADEKA STAB AO-30", "ADEKA STAB AO-40", "ADEKA STAB AO-50", "ADEKA STAB AO-60", "ADEKA STAB AO-80" (all above, manufactured by ADEKA Co., Ltd.); "JP-360", "JP-308E", "JPE-10" (all above, manufactured by Johoku Chemical Industry Co., Ltd.); "SIMILIZER BHT", "SIMILIZER BBM-S", "SIMILIZER GA-80" (all above, manufactured by Sumitomo Chemical Co., Ltd.), and the like.

The amount of the antioxidant added is preferably 0.01 to 2.0% by mass, and more preferably 0.02 to 1.0% by mass, based on the total amount of the photopolymerizable compounds contained in the ink composition.

### <<Dispersant>>

The dispersant is not particularly limited as long as it is a compound capable of improving the dispersion stability of the light-emitting particles 90 in the ink composition. Dispersants are classified into low-molecular dispersants and high-molecular dispersants.

In the present specification, "low-molecular" means a molecule having the weight average molecular weight (Mw) of 5,000 or less, and "high-molecular" means a molecule having the weight average molecular weight (Mw) of more than 5,000. Note that in the present specification, the value measured by gel permeation chromatography (GPC) using polystyrene as a standard substance can be adopted as the "weight average molecular weight (Mw)".

The low-molecular dispersants include, for example, oleic acid; phosphorous atom-containing compounds such as triethyl phosphate, TOP (trioctylphosphine), TOPO (trioctylphosphine oxide), hexylphosphonic acid (HPA), tetradecylphosphonic acid (TDPA), and octylphosphinic acid (OPA); nitrogen atom-containing compounds such as oleylamine, octylamine, trioctylamine, and hexadecylamine; sulfur atom-containing compounds such as 1-decanethiol, octanethiol, dodecanethiol, and amylsulfide; and the like.

On the other hand, the high-molecular dispersants include, for example, acrylic resins, polyester resins, polyurethane resins, polyamide resins, polyether resins, phenol resins, silicone resins, polyurea resins, amino resins, polyamine resins (polyethyleneimine, polyallylamine, and the like), epoxy resins, polyimide resins, natural rosins such as wood rosins, gum rosins, tall oil rosin, modified rosins such as polymerized rosins, disproportionated rosins, hydrogenated rosins, oxide rosins, maleinized rosins, rosin amines, lime rosins, rosin alkylene oxide adducts, rosin alkyd adducts, rosin derivatives such as rosin modified phenols, and the like.

Note that as commercially available high-molecular dispersants, for example, DISPERBYK series manufactured by BYK-Chemie, TEGO Dispers series manufactured by Evonik, EFKA series manufactured by BASF, SOLSPERSE series manufactured by Lubrizol Japan, AJISPER series manufactured by Ajinomoto Fine Techno Co., Ltd., DISPARLON series manufactured by Kusumoto Kasei, FLOWLEN series manufactured by Kyoeisha Chemical Co., Ltd., and the like can be used.

The blending amount of the dispersant is preferably 0.05 to 10 parts by mass, and more preferably 0.1 to 5 parts by mass with respect to 100 parts by mass of the light-emitting particles 90.

### <<Leveling Agent>>

The leveling agent is not particularly limited, but a compound capable of reducing film thickness unevenness when forming a thin film of the light-emitting particles 90 is preferable.

Such leveling agents include, for example, alkyl carboxylates, alkyl phosphates, alkyl sulfonates, fluoroalkyl carboxylates, fluoroalkyl phosphates, fluoroalkyl sulfonates, polyoxyethylene derivatives, fluoroalkyl ethylene oxide derivatives, polyethylene glycol derivatives, alkylammonium salts, fluoroalkylammonium salts, and the like.

Specific examples of the leveling agent include, for example, "Megaface F-114", "Megaface F-251", "Megaface F-281", "Megaface F-410", "Megaface F-430", "Megaface F-444", "Megaface F-472SF", "Megaface F-477", "Megaface F-510", "Megaface F-511", "Megaface F-552", "Megaface F-553", "Megaface F-554", "Megaface F-555", "Megaface F-556", "Megaface F-557", "Megaface F-558", "Megaface F-559", "Megaface F-560", "Megaface F-561", "Megaface F-562", "Megaface F-563", "Megaface F-565", "Megaface F-567", "Megaface F-568", "Megaface F-569", "Megaface F-570", "Megaface F-571", "Megaface R-40", "Megaface R-41", "Megaface R-43", "Megaface R-94", "Megaface RS-72-K", "Megaface RS-75", "Megaface RS-76-E", "Megaface RS-76-NS", "Megaface RS-90", "Megaface EXP.TF-1367", "Megaface EXP.TF1437", "Megaface EXP.TF1537", "Megaface EXP.TF-2066" (all above, manufactured by DIC Corporation) and the like.

Other specific examples of the leveling agent include, for example, "Ftergent 100", "Ftergent 100C", "Ftergent 110", "Ftergent 150", "Ftergent 150CH", "Ftergent 100A-K", "Ftergent 300", "Ftergent 310", "Ftergent 320", "Ftergent 400SW", "Ftergent 251", "Ftergent 215M", "Ftergent 212M", "Ftergent 215M", "Ftergent 250", "Ftergent 222F", "Ftergent 212D", "FTX-218", "Ftergent 209F", "Ftergent 245F", "Ftergent 208G", "Ftergent 240G", "Ftergent 212P", "Ftergent 220P", "Ftergent 228P", "DFX-18", "Ftergent 601AD", "Ftergent 602A", "Ftergent 650A", "Ftergent 750FM", "FTX-730FM", "Ftergent 730FL", "Ftergent 710FS", "Ftergent 710FM", "Ftergent 710FL", "Ftergent 750LL", "FTX-730LS", "Ftergent 730LM" (all above, manufactured by Neos Co., Ltd.), and the like.

Other specific examples of the leveling agent include, for example, "BYK-300", "BYK-302", "BYK-306", "BYK-307", "BYK-310", "BYK-315", "BYK-320", "BYK-322", "BYK-323", "BYK-325", "BYK-330", "BYK-331", "BYK-333", "BYK-337", "BYK-340", "BYK-344", "BYK-370", "BYK-375", "BYK-377", "BYK-350", "BYK-352", "BYK-354", "BYK-355", "BYK-356", "BYK-358N", "BYK-361N", "BYK-357", "BYK-390", "BYK-392", "BYK-UV3500", "BYK-UV3510", "BYK-UV3570", "BYK-Silclean 3700" (all above, manufactured by BYK USA), and the like.

Other specific examples of the leveling agent include, for example, "TEGO Rad2100", "TEGO Rad2011", "TEGO Rad2200N", "TEGO Rad2250", "TEGO Rad2300", "TEGO Rad2500", "TEGO Rad2600", "TEGO Rad2650", "TEGO Rod2700", "TEGO Flow300", "TEGO Flow370", "TEGO Flow425", "TEGO Flow ATF2", "TEGO Flow ZFS460", "TEGO Glide100", "TEGO Glide110", "TEGO Glide130", "TEGO Glide410", "TEGO Glide411", "TEGO Glide415", "TEGO Glide432", "TEGO Glide440", "TEGO Glide450", "TEGO Glide482", "TEGO Glide A115", "TEGO Glide B1484", "TEGO Glide ZG400", "TEGO Twin4000", "TEGO Twin4100", "TEGO Twin4200", "TEGO Wet240", "TEGO Wet250", "TEGO Wet260", "TEGO Wet265", "TEGO Wet270", "TEGO Wet280", "TEGO Wet500", "TEGO Wet505", "TEGO Wet510", "TEGO Wet520", "TEGO Wet KL245" (all above, manufactured by Evonik Industries, Ltd.), and the like.

Other specific examples of the leveling agent include, for example, "FC-4430", "FC-4432" (all above, manufactured by 3M Japan Ltd.), "UNIDYNE NS" (all above, manufactured by Daikin Industries, Ltd.), "SURFLON S-241", "SURFLON S-242", "SURFLON S-243", "SURFLON S-420", "SURFLON S-611", "SURFLON S-651", "SURFLON S-386" (all above, manufactured by AGC Seimi Chemical Co., Ltd.), and the like.

Other specific examples of the leveling agent include, for example, "DISPARLON OX-880EF", "DISPARLON OX-881", "DISPARLON OX-883", "DISPARLON OX-77EF", "DISPARLON OX-710", "DISPARLON 1922", "DISPARLON 1927", "DISPARLON 1958", "DISPARLON P-410EF", "DISPARLON P-420", "DISPARLON P-425", "DISPARLON PD-7", "DISPARLON 1970", "DISPARLON 230" "DISPARLON LF-1980", "DISPARLON LF-1982", "DISPARLON LF-1983", "DISPARLON LF-1084", "DISPARLON LF-1985", "DISPARLON LHP-90", "DISPARLON LHP-91", "DISPARLON LHP-95", "DISPARLON LHP-96", "DISPARLON OX-715", "DISPARLON 1930N", "DISPARLON 1931", "DISPARLON 1933", "DISPARLON 1934", "DISPARLON 1711EF", "DISPARLON 1751N", "DISPARLON 1761", "DISPARLON LS-009", "DISPARLON LS-001", "DISPARLON LS-050" (all above, manufactured by Kusumoto Kasei Co., Ltd.), and the like.

Other specific examples of the leveling agent include, for example, "PF-151N", "PF-636", "PF-6320", "PF-656", "PF-6520", "PF-652-NF", "PF-3320" (all above, manufactured by OMNOVA SOLUTIONS), "POLYFLOW No.7", "POLYFLOW No.50E", "POLYFLOW No.50EHF", "POLYFLOW No.54N", "POLYFLOW No.75", "POLYFLOW No.77", "POLYFLOW No.85", "POLYFLOW No.85HF", "POLYFLOW No.90", "POLYFLOW No.90D-50", "POLYFLOW No.95", "POLYFLOW No.99C", "POLYFLOW KL-400K", "POLYFLOW KL-400HF", "POLYFLOW KL-401", "POLYFLOW KL-402", "POLYFLOW KL-403", "POLYFLOW KL-404", "POLYFLOW KL-100", "POLYFLOW LE-604", "POLYFLOW KL-700", "FLOWLEN AC-300", "FLOWLEN AC-303", "FLOWLEN AC-324", "FLOWLEN AC-326F", "FLOWLEN AC-530", "FLOWLEN AC-903", "FLOWLEN AC-903HF", "FLOWLEN AC-1160", "FLOWLEN AC-1190", "FLOWLEN AC-2000", "FLOWLEN AC-2300C", "FLOWLEN AO-82", "FLOWLEN AO-98", "FLOWLEN AO-108" (all above, manufactured by Kyoeisha Chemical Co., Ltd.), and the like.

Further, other specific examples of the leveling agent include, for example, "L-7001", "L-7002", "8032ADDITIVE", "57ADDTIVE", "L-7064", "FZ-2110", "FZ-2105", "67ADDTIVE", "8616ADDTIVE" (all above, manufactured by Toray Dow Silicone Co., Ltd.) and the like.

The amount of the leveling agent added is preferably 0.005 to 2% by mass, and more preferably 0.01 to 0.5% by mass, based on the total amount of the photopolymerizable compounds contained in the ink composition.

### <<Chain Transfer Agent>>

The chain transfer agent is a component used for the purpose of further improving the adhesion of the ink composition to the substrate.

The chain transfer agents include, for example, aromatic hydrocarbons; halogenated hydrocarbons such as chloroform, carbon tetrachloride, carbon tetrabromide, and bromotrichloromethane; mercaptan compounds such as octyl mercaptan, n-butyl mercaptan, n-pentyl mercaptan, n-hexadecyl mercaptan, n-tetradecylmer, n-dodecyl mercaptan, t-tetradecyl mercaptan, and t-dodecyl mercaptan; thiol compounds such as hexanedithiol, decandithiol, 1,4-butanediol bisthiopropionate, 1,4-butanediol bisthioglycolate, ethylene glycol bisthioglycolate, ethylene glycol bisthiopropionate, trimethylolpropane tristhioglycolate, trimethylolpropane tristhiopropionate, trimethylolpropane tris(3-mercaptobutyrate), pentaerythritol tetrakisthioglycolate, pentaerythritol tetrakisthiopropionate, tris(2-hydroxyethyl) trimercaptopropionate isocyanurate, 1,4-dimethylmercaptobenzene, 2,4,6-trimercapto-s-triazine, 2-(N,N-dibutylamino)-4,6-dimercapto-s-triazine; sulfide compounds such as dimethylxanthogen disulfide, diethylxantogen disulfide, diisopropylxantogen disulfide, tetramethylthiuram disulfide, tetraethylthiuram disulfide, tetrabutylthiuram disulfide; N,N-dimethylaniline, N,N-divinylaniline, pentaphenylethane, α-methylstyrene dimer, acrolein, allyl alcohol, terpinolene, α-terpinene, γ-terpinene, and dipentene, but 2,4-diphenyl-4-methyl-1-pentene and thiol compounds are preferable.

As a specific example of the chain transfer agent, for example, compounds represented by the following general formulas (9-1) to (9-12) are preferable.

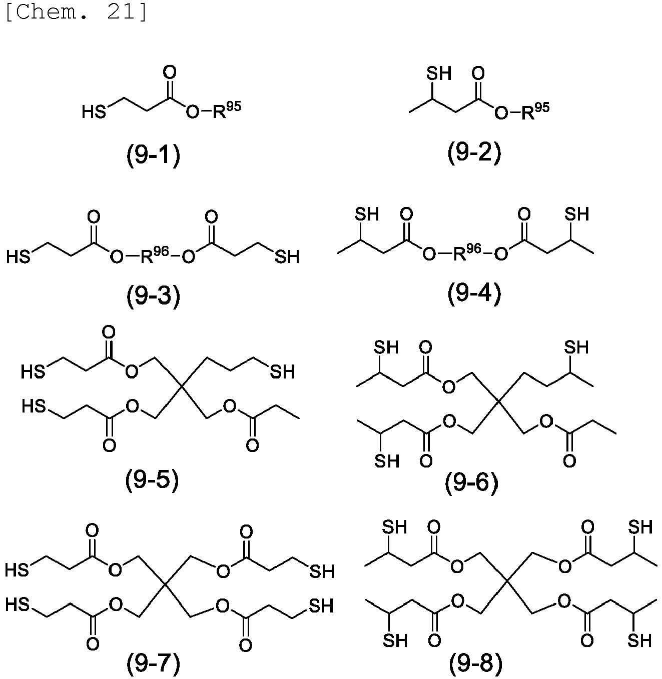

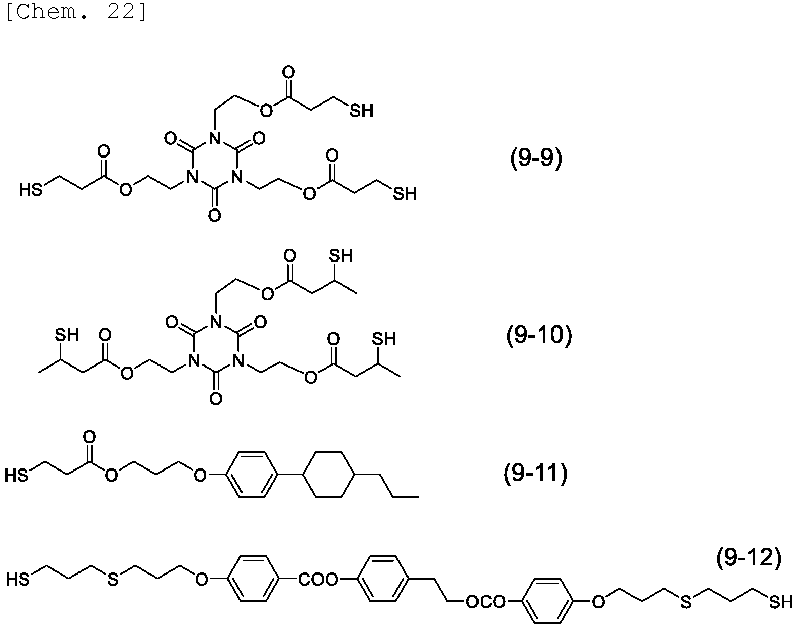

In the formula, R⁹⁵ represents an alkyl group having 2 to 18 carbon atoms, where the alkyl group may be a straight chain or a branched chain, and in one or more methylene groups in the alkyl group, the oxygen atom and the sulfur atom may be substituted with an oxygen atom, a sulfur atom, -CO-, -OCO-, -COO- or -CH=CH- without being directly bonded to each other.

R⁹⁶ represents an alkylene group having 2 to 18 carbon atoms, where in one or more methylene groups in the alkylene group, the oxygen atom and the sulfur atom may be substituted with an oxygen atom, a sulfur atom, -CO-, -OCO-, -COO- or - CH=CH- without being directly bonded to each other.

The amount of the chain transfer agent added is preferably 0.1 to 10% by mass, and more preferably 1.0 to 5% by mass, based on the total amount of the photopolymerizable compounds contained in the ink composition.

### <<Dispersion Aid>>

The dispersion aids include, for example, organic pigment derivatives such as phthalimide methyl derivatives, phthalimide sulfonic acid derivatives, phthalimide N-(dialkylamino)methyl derivatives, phthalimide N-(dialkylaminoalkyl) sulfonic acid amide derivatives. These dispersion aids may be used alone or in combination of two or more.

### <<Thermoplastic resin>>

The thermoplastic resins include, for example, urethane resins, acrylic resin, polyamide resins, polyimide resins, styrene maleic acid resins, styrene maleic anhydride resins, polyester acrylate resins, and the like.

### <<Sensitizer>>

As the sensitizer, amines that do not cause an addition reaction with the photopolymerizable compound can be used. Such sensitizers include, for example, trimethylamine, methyldimethanolamine, triethanolamine, p-diethylaminoacetophenone, ethyl p-dimethylaminobenzoate, isoamyl p-dimethylaminobenzoate, N,N-dimethylbenzylamine, 4,4'-bis(diethylamino)benzophenone, and the like.

### <<Light-Scattering Particles>>

The light-scattering particles are preferably, for example, optically inactive inorganic fine particles. The light-scattering particles can scatter the light from the light source unit irradiating the light-emitting layer (light conversion layer).

Materials constituting the light-scattering particles include, for example, metals per se such as tungsten, zirconium, titanium, platinum, bismuth, rhodium, palladium, silver, tin, platinum, and gold; metal oxides such as silica, barium sulfate, barium carbonate, calcium carbonate, talc, titanium oxide, clay, kaolin, barium sulfate, barium carbonate, calcium carbonate, alumina white, titanium oxide, magnesium oxide, barium oxide, aluminum oxide, bismuth oxide, zirconium oxide, and zinc oxide; metal carbonates such as magnesium carbonate, barium carbonate, bismuth hypocarbonate, and calcium carbonate; metal hydroxides such as aluminum hydroxide; composite oxides such as barium zirconate, calcium zirconate, calcium titanate, barium titanate, strontium titanate, and metal salts such as bismuth hyponitrate, and the like.

Among them, a material constituting the light-scattering particles contains preferably at least one selected from the group consisting of titanium oxide, alumina, zirconium oxide, zinc oxide, calcium carbonate, barium sulfate, and silica, and more preferably at least one selected from the group consisting of titanium oxide, barium sulfate, and calcium carbonate, from the viewpoint of better excellency in the effect of reducing leaked light.

### <Preparation Method of Ink Composition>

The ink composition as described above can be prepared by dispersing the light-emitting particles 90 in a solution in which a photopolymerizable compound, a photopolymerization initiator and the like are mixed.

Dispersion of the light-emitting particles 90 can be performed by using, for example, a disperser such as a ball mill, a sand mill, a bead mill, a three-roll mill, a paint conditioner, an attritor, a dispersion stirrer, and an ultrasonic wave.

The viscosity of the ink composition used in the present invention is preferably in the range of 2 to 20 mPa·s, more preferably in the range of 5 to 15 mPa·s, and even more preferably in the range of 7 to 12 mPa·s, from the viewpoint of ejection stability during inkjet printing. In this case, since the meniscus shape of the ink composition in the ink ejection hole of the ejection head is stable, the ejection control of the ink composition (for example, the control of the ejection amount and the ejection timing) becomes easy. In addition, the ink composition can be smoothly ejected from the ink ejection holes. The viscosity of the ink composition can be measured by, for example, an E-type viscometer.

Further, the surface tension of the ink composition is preferably a surface tension suitable for the inkjet printing method. The specific value of the surface tension is preferably in the range of 20 to 40 mN/m, and more preferably in the range of 25 to 35 mN/m. By setting the surface tension in the above range, it is possible to suppress the occurrence of flight bending of the droplets of the ink composition. Note that the flight bending means that when the ink composition is ejected from the ink ejection holes, the landing position of the ink composition deviates from the target position by 30 µm or more.

### <Light-Emitting Element>

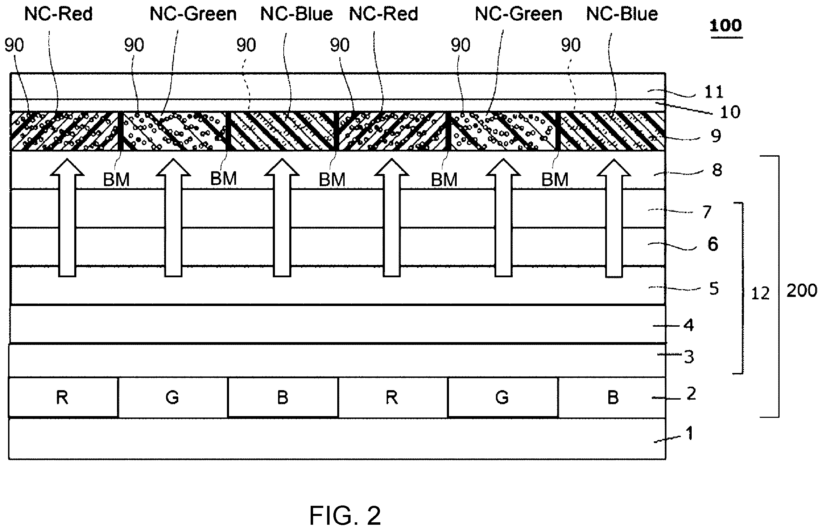

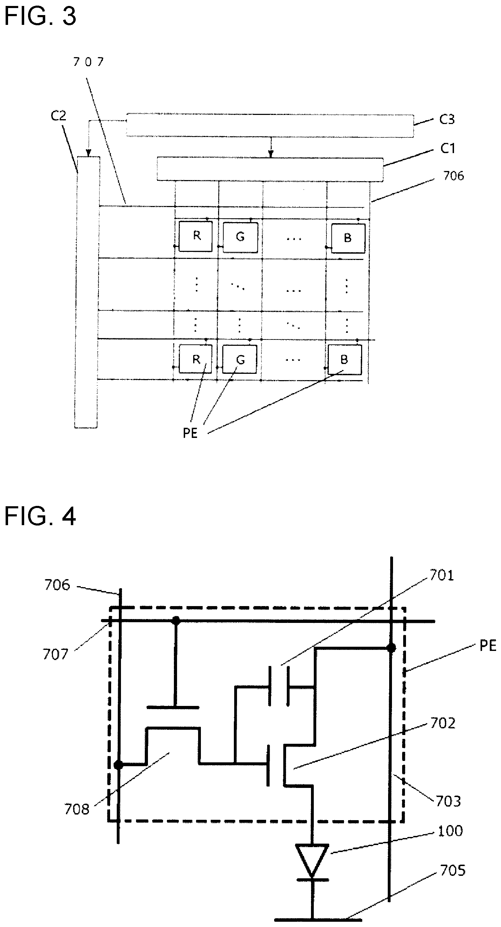

Fig. 2 is a cross-sectional view showing an embodiment of the light-emitting element of the present invention, and Figs. 3 and 4 are schematic views showing the configuration of an active matrix circuit, respectively.

Note that in Fig. 2, for convenience, the dimensions of each part and ratios thereof are exaggerated and may differ from the actual ones. Further, the materials, dimensions, and the like shown below are examples, and the present invention is not limited thereto, and can be appropriately changed without changing the gist thereof.

In the following, for convenience of explanation, the upper side of Fig. 2 is referred to as "upper side" or "upper", and the upper side is referred to as "lower side" or "lower". Further, in Fig. 2, in order to avoid complicating the drawing, the description of the hatching showing the cross section is omitted.

As shown in Fig. 2, a light-emitting element 100 includes a lower substrate 1, an EL light source unit 200 arranged on the lower substrate 1, a light conversion layer (light-emitting layer) 9 located on the EL light source unit 200 and containing the light-emitting particles 90, and an upper substrate 11 arranged on the light conversion layer 9 via an overcoat layer 10. Further, the EL light source unit 200 includes an anode 2, a cathode 8, and an EL layer 12 arranged between the anode 2 and the cathode 8.

The EL layer 12 shown in Fig. 2 includes a hole injection layer 3, a hole transport layer 4, a light-emitting layer 5, an electron transport layer 6, and an electron injection layer 7, which are sequentially laminated from the anode 2 side.

Such a light-emitting element 100 is a photoluminescence element in which the light emitted from the EL light source unit 200 (EL layer 12) is incident on the light conversion layer 9, the light-emitting particles 90 absorb the light, and light having a color corresponding to the light emitted color is emitted.

Below, each layer will be described in sequence.

### <<Lower Substrate 1 and Upper Substrate 11>>

The lower substrate 1 and the upper substrate 11 each have a function of supporting and/or protecting each layer constituting the light-emitting element 100.

When the light-emitting element 100 is a top emission type, the upper substrate 11 is composed of a transparent substrate. On the other hand, when the light-emitting element 100 is a bottom emission type, the lower substrate 1 is composed of a transparent substrate.

Here, the transparent substrate means a substrate capable of transmitting light having the wavelength in the visible light region, and the transparent includes colorless transparent, colored transparent, and translucent.

As the transparent substrate, for example, a glass substrate, a quartz substrate, a plastic substrate (resin substrate) composed of polyethylene terephthalate (PET), polyethylene naphthalate (PEN), polyether sulfone (PES), polyimide (PI), polycarbonate (PC), and the like, a metal substrate composed of iron, stainless steel, aluminum, copper, and the like, a silicon substrate, a gallium arsenic substrate, or the like can be used.

Further, when giving flexibility to the light-emitting element 100, for the lower substrate 1 and the upper substrate 11, a plastic substrate (a substrate composed of a polymer material as a main material) and a metal substrate having a relatively small thickness are selected, respectively.

The thickness of each of the lower substrate 1 and the upper substrate 11 is not particularly limited, but is preferably in the range of 100 to 1,000 µm, and more preferably in the range of 300 to 800 µm.

Note that either or both of the lower substrate 1 and the upper substrate 11 can be omitted depending on the usage pattern of the light-emitting element 100.

As shown in Fig. 3, on the lower substrate 1, a signal line drive circuit C1 and a scanning line drive circuit C2 for controlling the supply of current to the anode 2 constituting the pixel electrode PE represented by R, G, and B, a control circuit C3 for controlling the operation of these circuits, a plurality of signal lines 706 connected to the signal line drive circuit C1, and a plurality of scanning lines 707 connected to the scanning line drive circuit C2 are provided.

Further, as shown in Fig. 4, a condenser 701, a drive transistor 702, and a switching transistor 708 are provided in the vicinity of the intersection of each signal line 706 and each scanning line 707.

In the condenser 701, one electrode is connected to the gate electrode of the drive transistor 702, and the other electrode is connected to the source electrode of the drive transistor 702.

In the drive transistor 702, the gate electrode is connected to one electrode of the condenser 701, the source electrode is connected to the other electrode of the condenser 701 and the power supply line 703 that supplies the drive current, and the drain electrode is connected to the anode 4 of the EL light source unit 200.

In the switching transistor 708, the gate electrode is connected to the scanning line 707, the source electrode is connected to the signal line 706, and the drain electrode is connected to the gate electrode of the drive transistor 702.

Further, in the present embodiment, a common electrode 705 constitutes the cathode 8 of the EL light source unit 200.

Note that the drive transistor 702 and the switching transistor 708 can be composed of, for example, a thin film transistor.

The scanning line drive circuit C2 supplies or cuts off the scanning voltage according to the scanning signal to the gate electrode of the switching transistor 708 via the scanning line 707, and turns on or off the switching transistor 708. As a result, the scanning line drive circuit C2 adjusts the timing at which the signal line drive circuit C1 writes the signal voltage.

On the other hand, the signal line drive circuit C1 supplies or cuts off the signal voltage according to the video signal to the gate electrode of the drive transistor 702 via the signal line 706 and the switching transistor 708, and adjusts the amount of the signal current supplied to the EL light source unit 200.

Therefore, the scanning voltage is supplied from the scanning line drive circuit C2 to the gate electrode of the switching transistor 708, and when the switching transistor 708 is turned on, the signal voltage is supplied from the signal line drive circuit C1 to the gate electrode of the switching transistor 708.

At this time, the drain current corresponding to this signal voltage is supplied to the EL light source unit 200 as a signal current from the power supply line 703. As a result, the EL light source unit 200 emits light in response to the supplied signal current.

### <<EL Light Source Unit 200>>

### [Anode 2]

The anode 2 has a function of supplying holes from an external power source toward the light-emitting layer 5.

The constituent material of the anode 2 (anode material) is not particularly limited, but includes, for example, a metal such as gold (Au), a metal halide such as copper iodide (CuI), metal oxides such as indium tin oxide (ITO), tin oxide (SnO₂), and zinc oxide (ZnO). These may be used alone or in combination of two or more.

The thickness of the anode 2 is not particularly limited, but is preferably in the range of 10 to 1,000 nm, and more preferably in the range of 10 to 200 nm.

The anode 2 can be formed by, for example, a dry film forming method such as a vacuum vapor deposition method or a sputtering method. At this time, the anode 2 having a predetermined pattern may be formed by a photolithography method or a method using a mask.

### [Cathode 8]

The cathode 8 has a function of supplying electrons from an external power source toward the light-emitting layer 5.

The constituent material of the cathode 8 (cathode material) is not particularly limited, but includes, for example, lithium, sodium, magnesium, aluminum, silver, sodium-potassium alloy, magnesium/aluminum mixture, magnesium/silver mixture, magnesium/indium mixture, aluminum/aluminum oxide (Al₂O₃) mixture, rare earth metals, and the like. These may be used alone or in a combination of two or more.

The thickness of the cathode 8 is not particularly limited, but is preferably in the range of 0.1 to 1,000 nm, and more preferably in the range of 1 to 200 nm.

The cathode 3 can be formed by, for example, a dry film forming method such as a vapor deposition method or a sputtering method.

### [Hole Injection Layer 3]

The hole injection layer 3 has a function of receiving the holes supplied from the anode 2 and injecting them into the hole transport layer 4. The hole injection layer 3 only needs to be provided as needed and may be omitted.

The constituent material of the hole injection layer 3 (hole injection material) is not particularly limited, but includes, for example, phthalocyanine compounds such as copper phthalocyanine; triphenylamine derivatives such as 4,4',4"-tris[phenyl(m-tolyl)amino]triphenylamine; cyano compounds such as 1,4,5,8,9,12-hexazatriphenylene hexacarbonitrile, 2,3,5,6-tetrafluoro-7,7,8,8-tetracyanoquinodimethane; metal oxides such as vanadium oxide, molybdenum oxide; amorphous carbon; polymers such as polyaniline (emeraldine), poly(3,4-ethylenedioxythiophene)-poly(styrene sulfonic acid) (PEDOT)-PSS), polypyrrole, and the like.

Among these, as the hole injection material, a polymer is preferable, and PEDOT-PSS is more preferable.

Further, as the hole injection material described above, one type may be used alone, or two or more types may be used in a combination.

The thickness of the hole injection layer 3 is not particularly limited, but is preferably in the range of 0.1 to 500 mm, more preferably in the range of 1 to 300 nm, and even more preferably in the range of 2 to 200 nm.

The hole injection layer 3 may have a single-layer configuration or a laminated configuration in which two or more layers are laminated.

Such a hole injection layer 4 can be formed by a wet film forming method or a dry film forming method.

When the hole injection layer 3 is formed by a wet film forming method, an ink containing the hole injection material described above is usually applied by various coating methods, and the obtained coating film is dried. The coating method is not particularly limited and includes, for example, an inkjet printing method (droplet ejection method), a spin coating method, a casting method, an LB method, a letterpress printing method, a gravure printing method, a screen printing method, and a nozzle printing method.

On the other hand, when the hole injection layer 3 is formed by a dry film forming method, a vacuum vapor deposition method, a sputtering method or the like can be preferably used.

### [Hole Transport Layer 4]

The hole transport layer 4 has a function of receiving holes from the hole injection layer 3 and efficiently transporting them to the light-emitting layer 6. Further, the hole transport layer 4 may have a function of preventing the transport of electrons. The hole transport layer 4 only needs to be provided as needed and may be omitted.

The constituent material of the hole transport layer 4 (hole transport material) is not particularly limited and includes, for example, low molecular weight triphenylamine derivatives such as TPD (N,N'-diphenyl-N,N'-di(3-methylphenyl)-1,1'-biphenyl-4,4'diamine), α-NPD (4,4'-bis[N-(1-naphthyl)-N-phenylamino]biphenyl), m-MTDATA (4,4' ,4"-tris(3-methylphenylphenylamino)triphenylamine); polyvinylcarbazole; conjugated compound polymers such as poly [N,N'-bis(4-butylphenyl)-N,N'-bis(phenyl)-benzidine] (poly-TPA), polyfluorene (PF), poly[N,N'-bis(4-butylphenyl)-N,N'-bis(phenyl)-benzidine (Poly-TPD), poly[(9,9-dioctylfluorenyl-2,7-diyl)-co-(4,4'-(N-(sec-butylphenyl)diphenylamine)) (TFB), polyphenylene vinylene (PPV); and copolymers containing these monomer units.

Among these, the hole transport material is preferably a triphenylamine derivative or a polymer compound obtained by polymerizing a triphenylamine derivative having a substituent introduced therein, and more preferably a polymer compound obtained by polymerizing a triphenylamine derivative having a substituent introduced therein.

Further, as the hole transport material described above, one type may be used alone, or two or more types may be used in a combination.

The thickness of the hole transport layer 4 is not particularly limited, but is preferably in the range of 1 to 500 nm, more preferably in the range of 5 to 300 nm, and even more preferably in the range of 10 to 200 nm.

The hole transport layer 4 may have a single-layer configuration or a laminated configuration in which two or more layers are laminated.

Such a hole transport layer 4 can be formed by a wet film forming method or a dry film forming method.

When the hole transport layer 4 is formed by a wet film forming method, an ink containing the hole transport material described above is usually applied by various coating methods, and the obtained coating film is dried. The coating method is not particularly limited, and includes, for example, an inkjet printing method (droplet ejection method), a spin coating method, a casting method, an LB method, a letterpress printing method, a gravure printing method, a screen printing method, and a nozzle printing method.

On the other hand, when the hole transport layer 4 is formed by a dry film forming method, a vacuum vapor deposition method, a sputtering method or the like can be preferably used.

### [Electron Injection Layer 7]

The electron injection layer 7 has a function of receiving the electrons supplied from the cathode 8 and injecting them into the electron transport layer 6. The electron injection layer 7 only needs to be provided as needed and may be omitted.

The constituent material of the electron injection layer 7 (electron injection material) is not particularly limited, but includes, for example, alkali metal chalcogenides such as Li₂O, LiO, Na₂S, Na₂Se, NaO; alkali earth metal chalcogenides such as CaO, BaO, SrO, BeO, BaS, MgO, CaSe; alkali metal halides such as CsF, LiF, NaF, KF, LiCl, KCl, NaCl; alkali metal salts such as 8-hydroxyquinolinolato lithium (Liq); alkaline earth metal halides such as CaF₂, BaF₂, SrF₂, MgF₂, BeF₂, and the like.

Among these, alkali metal chalcogenides, alkaline earth metal halides, and alkali metal salts are preferable.

Further, as the above-mentioned electron injection material, one type may be used alone, or two or more types may be used in a combination.

The thickness of the electron injection layer 7 is not particularly limited, but is preferably in the range of 0.1 to 100 nm, more preferably in the range of 0.2 to 50 nm, and even more preferably in the range of 0.5 to 10 nm.

The electron injection layer 7 may have a single-layer configuration or a laminated configuration in which two or more layers are laminated.

Such an electron injection layer 7 can be formed by a wet film forming method or a dry film forming method.

When the electron injection layer 7 is formed by a wet film forming method, an ink containing the above-mentioned electron injection material is usually applied by various coating methods, and the obtained coating film is dried. The coating method is not particularly limited, and includes, for example, an inkjet printing method (droplet ejection method), a spin coating method, a casting method, an LB method, a letterpress printing method, a gravure printing method, a screen printing method, and a nozzle printing method.

On the other hand, when the electron injection layer 7 is formed by a dry film forming method, a vacuum vapor deposition method, a sputtering method or the like can be applied.

### [Electron Transport Layer 8]

The electron transport layer 8 has a function of receiving electrons from the electron injection layer 7 and efficiently transporting them to the light-emitting layer 5. Further, the electron transport layer 8 may have a function of preventing the transport of holes. The electron transport layer 8 only needs to be provided as needed and may be omitted.

The constituent material of the electron transport layer 8 (electron transport material) is not particularly limited, and includes, for example, metal complex with quinoline skeleton or benzoquinoline skeleton such as tris(8-quinolilato)aluminum (Alq3), tris(4-methyl-8-quinolinolato)aluminum (Almq3), bis(10-hydroxybenzo[h]quinolinato)beryllium (BeBq2), bis(2-methyl-8-uinolinolate) (p-phenylphenolato)aluminum (BAlq), bis(8-quinolinolate) zinc (Znq); metal complexes with benzoxazoline skeleton such as bis [2- (2'-hydroxyphenyl)benzoxazolate] zinc (Zn(BOX)2); metal complex with benzothiazoline skeleton such as bis[2-(2'-hydroxyphenyl)benzothiazolate] zinc (Zn(BTZ)2); tri- or diazole derivatives such as 2-(4-biphenylyl)-5-(4-tert-butylphenyl)-1,3,4-oxaziazole (PBD), 3-(4-biphenylyl)-4-phenyl-5-(4-tert-butylphenyl)-1,2,4-triazole (TAZ), 1,3-bis[5-(p-tert-butylphenyl)-1,3,4-oxadiazol-2-yl] benzene (OXD-7), 9-[4-(5-phenyl-1,3,4-oxadiazol-2-yl)phenyl]carbazole (CO11); imidazole derivatives such as 2,2',2"-(1,3,5-benzenetriyl)tris (1-phenyl-1H-benzoimidazole) (TPBI), 2-[3-(dibenzothiophen-4-yl)phenyl]-1-phenyl-1H-benzoimidazole (mDBTBIm-II); quinoline derivatives; perylene derivatives; pyridine derivatives such as 4,7-diphenyl-1,10-phenanthroline (BPhen); pyrimidine derivatives; triazine derivatives; quinoxaline derivatives; diphenylquinone derivatives; nitro-substituted fluorene derivatives; metal oxides such as zinc oxide (ZnO), titanium oxide (TiO₂), and the like.

Among these, the electron transport material is preferably an imidazole derivative, a pyridine derivative, a pyrimidine derivative, a triazine derivative, or a metal oxide (inorganic oxide).

Further, the above-mentioned electron transport materials may be used alone or in a combination of two or more.

The thickness of the electron transport layer 7 is not particularly limited, but is preferably in the range of 5 to 500 nm, and more preferably in the range of 5 to 200 nm.

The electron transport layer 6 may be a single layer or a stack of two or more layers.

Such an electron transport layer 7 can be formed by a wet film forming method or a dry film forming method.

When the electron transport layer 6 is formed by a wet film forming method, an ink containing the electron transport material described above is usually applied by various coating methods, and the obtained coating film is dried. The coating method is not particularly limited, and includes, for example, an inkjet printing method (droplet ejection method), a spin coating method, a casting method, an LB method, a letterpress printing method, a gravure printing method, a screen printing method, and a nozzle printing method.

On the other hand, when the electron transport layer 6 is formed by a dry film forming method, a vacuum vapor deposition method, a sputtering method or the like can be applied.

### [Light-Emitting Layer 5]

The light-emitting layer 5 has a function of generating light emission by utilizing the energy generated by the recombination of holes and electrons injected into the light-emitting layer 5.

The light-emitting layer 5 preferably contains a light-emitting material (guest material or dopant material) and a host material. In this case, the mass ratio of the host material and the light-emitting material is not particularly limited, but is preferably in the range of 10:1 to 300:1.

As the light-emitting material, a compound capable of converting singlet excitation energy into light or a compound capable of converting triplet excitation energy into light can be used.

Further, the light-emitting material preferably contains at least one selected from the group consisting of an organic low-molecular fluorescent material, an organic polymer fluorescent material and an organic phosphorescent material.

Examples of compounds capable of converting singlet excitation energy into light include organic low-molecular fluorescent materials or organic polymer fluorescent materials that emit fluorescence.

As the organic low-molecular fluorescent material, a compound having an anthracene structure, a tetracene structure, a chrysene structure, a phenanthrene structure, a pyrene structure, a perylene structure, a stilbene structure, an acridone structure, a coumarin structure, a phenoxazine structure, or a phenothiazine structure is preferable.

Specific examples of the organic low-molecular fluorescent material include, for example, 5,6-bis[4-(10-phenyl-9-anthryl)phenyl]-2,2'-bipyridine, 5,6-bis[4'-(10-phenyl-9-anthril)biphenyl-4-yl]-2,2'-bipyridine (, N,N'-bis[4-(9H-carbazole-9-yl)phenyl]-N,N'-diphenylstilbene-4,4'-diamine, 4-(9H-carbazole-9-yl)-4'-(10-phenyl-9-anthril)triphenylamine, 4-(9H-carbazole-9-yl)-4'-(9,10-diphenyl-2-anthril)triphenylamine, N,9-diphenyl-N-[4-(10-phenyl-9-anthryl)phenyl]-9H-carbazole-3-amine, 4-(10-phenyl-9-anthril)-4'-(9-phenyl-9H-carbazole-3-yl)triphenylamine, 4-[4-(10-phenyl-9-anthryl)phenyl]-4'-(9-phenyl-9H-carbazole-3-yl)triphenylamine, perylene, 2,5,8,11-tetra(tert-butyl)perylene, N,N'-diphenyl-N,N'-bis[4-(9-phenyl-9H-fluoren-9-yl)phenyl]pyrene-1,6-diamine, N,N'-bis(3-methylphenyl)-N,N'-bis[3-(9-phenyl)-9H-fluoren-9-yl)phenyl]-pyrene-1,6-diamine, N,N'-bis(dibenzofuran-2-yl)-N,N'-diphenylpyrene-1,6-diamine, N,N'-bis(dibenzothiophen-2-yl)-N,N'-diphenylpyrene-1,6-diamine, N,N"-(2-tert-butylanthracene-9,10-diyldi-4,1-phenylene)bis[N,N',N'-triphenyl-1,4-phenylenediamine], N,9-diphenyl-N-[4-(9,10-diphenyl-2-anthryl)phenyl]-9H-carbazole-3-amine, N-[4-(9,10-diphenyl-2-anthryl)phenyl]-N,N' ,N'-triphenyl-1,4-phenylenediamine, N,N,N',N',N",N",N‴,N‴-octaphenyldibenzo[g,p] chrysene-2,7,10,15-tetraamine, coumarin 30, N-(9,10-diphenyl-2-anthril)-N,9-diphenyl-9H-carbazole-3-amine, N-(9,10-diphenyl-2-anthryl)-N,N' ,N'-triphenyl-1,4-phenylenediamine, N,N,9-triphenylanthracene-9-amine, coumarin 6, coumarin 545T, N,N'-diphenylquinacridone, rubrene, 5,12-bis(1,1'-biphenyl-4-yl)-6,11-diphenyltetracene, 2-(2-{2-[4-(dimethylamino)phenyl]ethenyl}-6-methyl-4H-pyran-4-ylidene)propandinitrile, 2-{2-methyl-6-[2-(2,3,6,7-tetrahydro-1H,5H-benzo[ij]quinolidine-9-yl)ethenyl]-4H-pyran-4-ylidene}propandinitrile, N,N,N',N'-tetrakis(4-methylphenyl)tetracene-5,11-diamine, 7,14-diphenyl-N,N,N' ,N'-tetrakis(4-methylphenyl)acenaphth[1,2-a]fluoranthen-3,10-diamine, 2-{2-isopropyl-6-[2-(1,1,7,7-tetramethyl-2,3,6,7-tetrahydro-1H,5H-benzo[ij]quinolidine-9-yl)ethenyl]-4H-pyran-4-ylidene}propandinitrile, 2-{2-tert-butyl-6-[2-(1,1,7,7-tetramethyl-2,3,6,7-tetrahydro-1H,5H-benzo[ij]quinolidine-9-yl)ethenyl]-4H-pyran-4-ylidene}propandinitrile, 2-(2,6-bis{2-[4-(dimethylamino)phenyl]ethenyl}-4H-pyran-4-ylidene)propandinitrile, 2-{2,6-bis[2-(8-methoxy-1,1,7,7-tetramethyl-2,3,6,7-tetrahydro-1H,5H-benzo[ij]quinolidine-9-yl)ethenyl]-4H-pyran-4-ylidene}propandinitrile, 5,10,15,20-tetraphenylbisbenzo[5,6]indeno[1,2,3-cd:1',2',3'-lm]perylene, and the like.

Specific examples of the organic polymer fluorescent material include, for example, homopolymers composed of units based on fluorene derivatives, copolymers composed of units based on fluorene derivatives and units based on tetraphenylphenylenediamine derivatives, homopolymers composed of units based on terphenyl derivatives, homopolymers composed of units based on diphenylbenzofluorene derivatives, and the like.

As a compound capable of converting triplet excitation energy into light, an organic phosphorescent material that emits phosphorescence is preferable.

Specific examples of the organic phosphorescent material include, for example, a metal complex containing at least one metal atom selected from the group consisting of iridium, rhodium, platinum, ruthenium, osmium, scandium, yttrium, gadolinium, palladium, silver, gold, and aluminum.

Among them, the organic phosphorescent material is preferably a metal complex containing at least one metal atom selected from the group consisting of iridium, rhodium, platinum, ruthenium, osmium, scandium, yttrium, gadrinium, and palladium, more preferably a metal complex containing at least one metal atom selected from the group consisting of iridium, rhodium, platinum, and ruthenium, and even more preferably an iridium complex or a platinum complex.

As the host material, it is preferable to use at least one compound having an energy gap larger than the energy gap of the light-emitting material. Further, when the light-emitting material is a phosphorescent material, it is preferable to select a compound having a triplet excitation energy larger than the triplet excitation energy (energy difference between the base state and the triplet excited state) of the light-emitting material as the host material.

Examples of the host material include tris (8-quinolinolato)aluminum (III), tris(4-methyl-8-quinolinolato)aluminum (III), bis(10-hydroxybenzo[h]quinolinato)berylium (II), bis(2-methyl-8-quinolinolato) (4-phenylphenolato) aluminum (III), bis (8-quinolinolato)zinc (II), bis[2- (2-benzoxazolyl)phenolato] zinc (II), bis[2-(2-benzothiazolyl)phenolato] zinc (II), 2-(4-biphenylyl)-5-(4-tert-butylphenyl)-1,3,4-oxadiazole, 1,3-bis[5- (p-tert-butylphenyl)-1,3,4-oxadiazol-2-yl]benzene, 3-(4-biphenylyl)-4-phenyl-5-(4-tert-butylphenyl)-1,2,4-triazole, 2,2',2"-(1,3,5-benzenetriyl)tris(1-phenyl-1H-benzoimidazole), bathophenanthroline, bathocuproine, 9-[4-(5-phenyl-1,3,4-oxadiazol-2-yl)phenyl]-9H-carbazole, 9,10-diphenylanthracene, N,N-diphenyl-9-[4-(10-phenyl-9-anthryl)phenyl]-9H-carbazole-3-amine, 4-(10-phenyl-9-anthryl)triphenylamine, N,9-diphenyl-N-{4-[4-(10-phenyl-9-anthryl)phenyl]phenyl}-9H-carbazole-3-amine, 6,12-dimethoxy-5,11-diphenylglycene, 9-[4-(10-phenyl-9-anthracenyl)phenyl]-9H-carbazole, 3,6-diphenyl-9-[4-(10-phenyl-9-anthryl)phenyl]-9H-carbazole, 9-phenyl-3-[4-(10-phenyl-9-anthryl)phenyl] -9H-carbazole, 7-[4-(10-phenyl-9-anthryl)phenyl]-7H-dibenzo[c,g]carbazole, 6-[3-(9,10-diphenyl-2-anthryl)phenyl]-benzo [b]naphtho[1,2-d]furan, 9-phenyl-10-{4-(9-phenyl-9H-fluoren-9-yl)biphenyl-4'-yl}anthracene, 9,10-bis(3,5-diphenylphenyl)anthracene, 9,10-di(2-naphthyl)anthracene, 2-tert-butyl-9,10-di(2-naphthyl)anthracene, 9,9'-bianthryl, 9,9'-(stilbene-3,3'-diyl)diphenanthrene, 9,9'-(stilbene-4,4'-diyl)diphenanthrene, 1,3,5-tri(1-pyrenyl)benzene, 5,12-diphenyltetracene or 5,12-bis (biphenyl-2-yl)tetracene, and the like. These host materials may be used alone or in a combination of two or more.

The thickness of the light-emitting layer 5 is not particularly limited, but is preferably in the range of 1 to 100 nm, and more preferably in the range of 1 to 50 nm.

Such a light-emitting layer 5 can be formed by a wet film forming method or a dry film forming method.

When the light-emitting layer 5 is formed by a wet film forming method, an ink containing the above-mentioned light-emitting material and host material is usually applied by various coating methods, and the obtained coating film is dried. The coating method is not particularly limited and includes an inkjet printing method (droplet ejection method), a spin coating method, a casting method, an LB method, a letterpress printing method, a gravure printing method, a screen printing method, and a nozzle printing method.

On the other hand, when the light-emitting layer 5 is formed by a dry film forming method, a vacuum vapor deposition method, a sputtering method or the like can be applied.

Note that the EL light source unit 200 may further have, for example, a bank (partition wall) for partitioning the hole injection layer 3, the hole transport layer 4, and the light-emitting layer 5.

The height of the bank is not particularly limited, but is preferably in the range of 0.1 to 5 µm, more preferably in the range of 0.2 to 4 µm, and even more preferably in the range of 0.2 to 3 µm.

The width of the bank opening is preferably in the range of 10 to 200 µm, more preferably in the range of 30 to 200 µm, and even more preferably in the range of 50 to 100 µm.

The length of the bank opening is preferably in the range of 10 to 400 µm, more preferably in the range of 20 to 200 µm, and even more preferably in the range of 50 to 200 µm.

Further, the inclination angle of the bank is preferably in the range of 10 to 100°, more preferably in the range of 10 to 90°, and even more preferably in the range of 10 to 80°.

### <<Light Conversion Layer 9>>

As shown in Fig. 2, the light conversion layer 9 comprises a red (R) light conversion pixel unit (NC-Red) including red light-emitting particles 90, a green (G) light conversion pixel unit (NC-Green) including nanocrystals for containing green light-emitting particles 90, and a blue (B) light conversion pixel unit (NC-Blue) including blue light-emitting particles 90.

In the light conversion layer 9 having such a configuration, when the light emitted from the corresponding EL layer 12 is incident on the light conversion pixel unit (NC-Red, NC-Green, NC-Blue), the light-emitting nanocrystal 90 convert the light into light having an emission spectrum in any of red (R), green (G), and blue (B). That is, the light conversion layer 9 can be said to be a light-emitting layer.

Further, a black matrix BM is arranged as a light-shielding unit between the red light conversion pixel unit (NC-Red), the green light conversion pixel unit (NC-Green), and the blue light conversion pixel unit (NC-Blue).

The red light conversion pixel unit (NC-Red), the green light conversion pixel unit (NC-Green), and the blue light conversion pixel unit (NC-Blue) may contain color materials corresponding to the respective colors.

The thickness of the light conversion layer 9 is not particularly limited, but is preferably in the range of 1 to 30 µm, and more preferably in the range of 3 to 20 µm.

Such a light conversion layer 9 can be formed by a wet film forming method, and can be formed by supplying the ink composition of the present invention by various coating methods, drying the obtained coating film, and then curing by irradiation with active energy rays (for example, ultraviolet rays), as necessary.

The coating method is not particularly limited, but for example, an inkjet printing method (piezo type or thermal type droplet ejection method), a spin coating method, a casting method, an LB method, a letterpress printing method, a gravure printing method, a screen printing method, a nozzle printing method, and the like. Here, the nozzle printing method is a method of applying the ink composition from the nozzle holes as a liquid column in a striped shape.

Among them, the inkjet printing method (particularly, the piezo type droplet ejection method) is preferable as the coating method. As a result, the heat load when ejecting the ink composition can be reduced, and problems are unlikely to occur in the light-emitting particles 90 (nanocrystals 91) per se.

The conditions of the inkjet printing method are preferably set as follows.

The ejection amount of the ink composition is not particularly limited, but is preferably 1 to 50 pL/time, more preferably 1 to 30 pL/time, and even more preferably 1 to 20 pL/time.

Further, the opening diameter of the nozzle hole is preferably in the range of 5 to 50 µm, and more preferably in the range of 10 to 30 µm. As a result, it is possible to improve the ejection accuracy of the ink composition while preventing clogging of the nozzle holes.

The temperature at which the coating film is formed is not particularly limited, but is preferably in the range of 10 to 50°C, more preferably in the range of 15 to 40°C, and even more preferably in the range of 15 to 30°C. By ejecting the droplets at such a temperature, crystallization of various components contained in the ink composition can be suppressed.

Further, the relative humidity at the time of forming the coating film is also not particularly limited, but is preferably in the range of 0.01 ppm to 80%, more preferably in the range of 0.05 ppm to 60%, even more preferably in the range of 0.1 ppm to 15%, particularly preferably in the range of 1 ppm to 1%, and most preferably in the range of 5 to 100 ppm. When the relative humidity is the above lower limit value or higher, it becomes easy to control the conditions when forming the coating film. On the other hand, when the relative humidity is not the above upper limit value or higher, the amount of water adsorbed on the coating film which may adversely affect the obtained light conversion layer 9 can be reduced.

The obtained coating film may be dried by sitting at room temperature (25°C) or by heating.

When the drying is performed by heating, the drying temperature is not particularly limited, but is preferably in the range of 40 to 150°C, and more preferably in the range of 40 to 120°C.

Further, the drying is preferably performed under reduced pressure, and more preferably performed under reduced pressure of 0.001 to 100 Pa.

Further, the drying time is preferably 1 to 90 minutes, and more preferably 1 to 30 minutes.

By drying the coating film under such drying conditions, not only the dispersion medium but also the dispersant and the like can be reliably removed from the coating film, and the external quantum efficiency of the obtained light conversion layer 9 can be further improved.

When the ink composition is cured by irradiation with active energy rays (for example, ultraviolet rays), for example, a mercury lamp, a metal halide lamp, a xenon lamp, an LED or the like is used as an irradiation source (light source) .

The wavelength of the light to be applied is preferably 200 nm or more, and more preferably 440 nm or less.

Further, the light irradiation amount (exposure amount) is preferably 10 mJ/cm² or more, and more preferably 4000 mJ/cm² or less.

### <<Overcoat Layer 10>>

The overcoat layer 10 has a function of protecting the light conversion layer 9 and adhering the upper substrate 11 to the light conversion layer 9.

Since the light-emitting element 100 of the embodiment is a top emission type, it is preferable that the overcoat layer 10 has transparency (light transmission).

As the constituent material of the overcoat layer 10, for example, an acrylic adhesive, an epoxy adhesive, or the like is preferably used.

The thickness of the overcoat layer 10 is not particularly limited, but is preferably in the range of 1 to 100 nm, and more preferably in the range of 1 to 50 nm.

The light-emitting element 100 can be configured as a bottom emission type instead of the top emission type.

Further, the light-emitting element 100 can use another light source instead of the EL light source unit 200.

Further, the light-emitting element 100 can be configured as an electroluminescence element instead of the photoluminescence element. In this case, in the element configuration shown in Fig. 2, the light conversion layer 9 may be omitted and the light-emitting layer 5 may be composed of the light conversion layer 9.

Although the method for producing light-emitting particles, the light-emitting particles, the light-emitting particle dispersion, the ink composition and the light-emitting element of the present invention have been described above, the present invention is not limited to the configuration of the above-described embodiment.

For example, the light-emitting particles, the light-emitting particle dispersion, the ink composition, and the light-emitting element of the present invention may each have any other configuration additionally or any configuration that exerts the same function may be replaced with, in the configuration of the above-described embodiment.

Further, the method for producing light-emitting particles of the present invention may have any other desired step or any step that exerts the same effect may be replaced with, in the configuration of the above-described embodiment. Examples

Hereinafter, the present invention will be specifically described with reference to examples, but the present invention is not limited thereto.

### 1. Preparation of parent particles

### (Parent Particles 1)

First, 0.81 g of cesium carbonate, 40 mL of 1-octadecene, and 2.5 mL of oleic acid were mixed to obtain a mixed solution. Next, the mixed solution was dried under reduced pressure at 120°C for 10 minutes, and then heated at 150°C under an argon atmosphere. As a result, a cesium-oleic acid solution was obtained.

On the other hand, 138.0 mg of lead (II) bromide and 10 mL of 1-octadecene were mixed to obtain a mixed solution. Next, the mixed solution was dried under reduced pressure at 120°C for 10 minutes, and then 1 mL of 3-aminopropyltriethoxysilane was added to the mixed solution under an argon atmosphere.

Then, 1.3 mL of the cesium-oleic acid solution was added to the mixed solution at 140°C, and reacted by heating and stirring for 5 seconds, and then cooled in an ice bath.

Next, the reaction solution was stirred in the air (23°C, humidity 45%) for 60 minutes, and then 20 mL of ethanol was added.

The obtained suspension was centrifuged (3,000 rpm, 5 minutes) and the solid matter was recovered.

This recovered solid matter was added to 16 mL of hexane to obtain a hexane dispersion of parent particles 1 (0.01 mol/L).

Note that the nanocrystals of the parent particle 1 were perovskite-type lead cesium tribromide crystals, and the average particle size was 10 nm. Further, the surface layer was a layer composed of 3-aminopropyltriethoxysilane and the thickness thereof was 1 nm.

### (Parent Particle 2)

First, 15.0 mg of lead (II) bromide and 4.5 mg of methylamine hydrobromide was added to 1 mL of N, N-dimethylformamide solution to obtain a solution containing a raw material compound for semiconductor nanocrystals.

On the other hand, 0.18 mL of 3-aminopropyltriethoxysilane, 0.2 mL of oleic acid, and 0.2 mL of toluene were mixed to obtain an ethoxysilane solution. Then, 29 µL of the above-mentioned ethoxysilane solution was added to the above-mentioned solution containing the raw material compound of the semiconductor nanocrystals in the air at room temperature to obtain a mixture.

Immediately after that, the obtained mixture was added to 20 mL of toluene, stirred at room temperature for 5 seconds, and then centrifuged (12,100 rpm, 5 minutes), and the solid matter was recovered.

This recovered solid matter was added to 4 mL of toluene to obtain a toluene dispersion (0.01 mol/L) of the parent particles 2.

Note that the nanocrystals of the parent particle 1 were perovskite-type lead ammonium tribromide crystals and the average particle size was 11 nm. Further, the surface layer was a layer composed of 3-aminopropyltriethoxysilane and the thickness thereof was 1 nm.

### 2. Preparation of light-emitting particles

### (Example 1)

First, 190 parts by mass of heptane was supplied to a four-necked flask equipped with a thermometer, a stirrer, a reflux condenser, and a nitrogen gas introduction tube, and the temperature was raised to 85°C.

Next, after reaching the same temperature, a mixture of 66.5 parts by mass of lauryl methacrylate, 3.5 parts by mass of dimethylaminoethyl methacrylate, and 0.5 parts by mass of dimethyl-2,2-azobis(2-methylpropionate) dissolved in 20 parts by mass of heptane was added dropwise to the heptane in the four-necked flask over 3.5 hours, and even after the addition was completed, the mixture was kept at the same temperature for 10 hours to continue the reaction.

After lowering the temperature of the reaction solution to 50°C, a solution of 0.01 part by mass of t-butylpyrocatechol dissolved in 1.0 part by mass of heptane was added, and 1.0 part by mass of glycidyl methacrylate was further added. After that, the temperature was raised to 85°C, and the reaction was continued at the same temperature for 5 hours. As a result, a solution containing the polymer (P) was obtained.

Note that the amount of non-volatile content (NV) contained in the solution was 25.1% by mass, and the weight average molecular weight (Mw) of the polymer (P) was 10,000.

Next, 26 parts by mass of heptane, 3 parts by mass of parent particles 1, and 3.6 parts by mass of polymer (P) were supplied to a four-necked flask equipped with a thermometer, a stirrer, a reflux condenser, and a nitrogen gas introduction tube.

Further, 0.2 parts by mass of ethylene glycol dimethacrylate, 0.4 parts by mass of methyl methacrylate, and 0.12 parts by mass of dimethyl-2,2-azobis(2-methylpropionate) were supplied to the above-mentioned four-necked flask.

After that, the mixed solution in the four-necked flask was stirred at room temperature for 30 minutes, then heated to 80°C, and the reaction was continued at the same temperature for 15 hours. After completion of the reaction, the polymer that was not adsorbed on the parent particles 1 was separated by centrifugation, and then the precipitated light-emitting particles were dispersed in heptane to obtain a solution of the light-emitting particles 1 in heptane. When observed with a transmission electron microscope, a polymer layer having a thickness of about 10 nm was formed on the surfaces of the parent particles.

### (Example 2)

A solution of light-emitting particles 2 in heptane was obtained in the same manner as in Example 1 except that the parent particles 2 were used instead of the parent particles 1. When observed with a transmission electron microscope, a polymer layer having a thickness of about 10 nm was formed on the surfaces of the parent particles.

### (Comparative Example 1)

First, 0.814 parts by mass of cesium carbonate, 40 parts by mass of octadecene, and 2.5 parts by mass of oleic acid were supplied to a four-necked flask equipped with a thermometer, a stirrer, a septum, and a nitrogen gas introduction tube, and the mixture was heated and stirred at 150°C under a nitrogen atmosphere until a uniform solution was obtained. After all were dissolved, it was cooled to 100°C to obtain a cesium oleate solution.

Next, 0.069 parts by mass of lead (II) bromide and 5 parts by mass of octadecene were supplied to a four-necked flask equipped with a thermometer, a stirrer, a septum, and a nitrogen gas introduction tube, and the mixture was heated and stirred at 120°C for 1 hour under a nitrogen atmosphere. Further, 0.5 parts by mass of oleylamine and 0.5 parts by mass of oleic acid were supplied, and the mixture was heated and stirred under a nitrogen atmosphere at 160°C until a uniform solution was obtained.

Next, 0.4 parts by weight of the cesium oleate solution was supplied, and the mixture was stirred at 160°C for 5 seconds, and then the reaction vessel was ice-cooled. The obtained reaction solution was separated by centrifugation and the supernatant was removed to obtain 0.45 parts by mass of a perovskite-type cesium lead tribromide crystals in which oleic acid and oleylamine were coordinated.

0.2 parts by mass of the obtained perovskite-type cesium lead tribromide crystals coordinated with oleic acid and oleylamine was added to 2 parts by mass of heptane and dispersed to obtain a heptane solution.

### (Comparative Example 2)

First, 1.47 parts by mass of lead (II) bromide, 0.45 parts by mass of methylamine hydrobromide, 1 part by mass of oleylamine, 1 part by mass of oleic acid, and 100 parts by mass of N,N-dimethylformamide were supplied and dissolved in a four-necked flask equipped with a thermometer, a stirrer, a septum, and a nitrogen gas introduction tube.

Next, the obtained solution was added to 2000 parts by mass of toluene with vigorous stirring. The obtained reaction solution was separated by centrifugation and the supernatant was removed to obtain 1.2 parts by mass of a perovskite-type methylammonium lead bromide crystals coordinated with oleic acid and oleylamine.

0.2 parts by mass of the obtained perovskite-type methylammonium lead bromide crystals coordinated with oleic acid and oleylamine was added to 2 parts by mass of heptane and dispersed to obtain a heptane solution.

### 3. Evaluation of light-emitting particle dispersion

### 3-1. Quantum yield retention rate

The quantum yield of the heptane solution obtained in each Example and each Comparative Example was measured with an absolute PL quantum yield measuring device ("Quantaurus-QY" manufactured by Hamamatsu Photonics Co., Ltd.). The quantum yield retention rate of each heptane solution (value obtained by dividing the quantum yield after standing in the air for 10 days after preparation by the quantum yield immediately after preparation) was calculated.

Note that the higher the quantum yield retention rate, the higher the stability of the light-emitting particles to oxygen gas and water vapor.

### 3-2. Dispersion stability

The heptane solutions obtained in each Example and each Comparative Example were left in the air for 10 days, then the presence or absence of a precipitate was determined and evaluated according to the following criteria.
A: No precipitate has formed.
B: A very small amount of precipitate is formed.
C: A slightly more precipitate is generated.
These results are summarized in Table 1 below.

**[Table 1]**

| | Quantum Yield Retention Rate (%) | Dispersion Stability |
|---|---|---|
| Example 1 | 95 | B |
| Example 2 | 86 | A |
| Comparative Example 1 | 76 | C |
| Comparative Example 2 | 72 | C |

From the results in Table 1, it can be seen that the light-emitting particles produced by the production method of the present invention have high stability to oxygen gas and water vapor, and high dispersion stability to heptane.

### 4. Ink composition and light conversion layer

### <Preparation of light-emitting particles/photopolymerizable compound dispersion>

### (Preparation Example 1)

Heptane is removed from the heptane solution obtained in Example 1 by a rotary evaporator, and then lauryl acrylate (manufactured by Kyoeisha Chemical Co., Ltd.), a photopolymerizable compound, is mixed and stirred by the rotary evaporator to obtain light-emitting particles/photopolymerizable compound dispersion 1 (content of light-emitting particles 1: 50% by mass).

### (Preparation Example 2)

Light-emitting particles/photopolymerizable compound dispersion 2 (content of light-emitting particles 2: 50% by mass) was obtained in the same manner as in Preparation Example 1 except that the heptane solution obtained in Example 2 was used instead of the heptane solution obtained in Example 1.

### <Preparation of light-scattering particle dispersion>

First, 55 parts by mass of titanium oxide particles (manufactured by Teika Co., Ltd., "JR-806"), 2 parts by mass of a high-molecular dispersant (manufactured by BYK Chemie, "Ajisper PB-821"), and 45 parts by mass of 1,6-hexanediol diacrylate (manufactured by Kyoeisha Chemical Co., Ltd.), which is a photopolymerizable compound, and 0.03 parts by mass of 4-methoxyphenol (manufactured by Seiko Chemical Co., Ltd., "METHOQUINONE"), which is a polymerization inhibitor were blended. Note that the average particle size (volume average diameter) of the titanium oxide particles is 300 nm.

Next, after adding zirconia beads (diameter: 0.3 mm) to the obtained formulation, the formulation was dispersed by shaking for 2 hours using a paint conditioner. As a result, a light scattering particle dispersion 1 was obtained.

### (Example 3)

First, 27.5 parts by mass of 1,6-hexanediol diacrylate", a photopolymerizable compound, was mixed with 3 parts by mass of a photopolymerization initiator (manufactured by IGM Resin, "Omnirad TPO") and 0.5 parts by mass of an antioxidant (manufactured by Johoku Chemical Co., Ltd., "JPE-10") and stirred at room temperature to uniformly dissolve.

65 parts by mass of light-emitting particles/photopolymerizable compound dispersion 1 and 4 parts by mass of light scattering particle dispersion 1 were further mixed with the obtained solution, and the mixture was stirred at room temperature to uniformly disperse.

Next, the obtained dispersion liquid was filtered through a filter having a pore size of 5 µm to obtain an ink composition 1.

Next, the obtained ink composition 1 was applied onto a glass substrate ("EagleXG" manufactured by Corning Inc.) with a spin coater so that the film thickness after drying was 10 µm.

The obtained film was irradiated with ultraviolet light having the LED lamp wavelength of 365 nm under a nitrogen atmosphere at an exposure amount of 2000 mJ/cm². As a result, the ink composition 1 was cured to form a layer (light conversion layer 1) made of the cured product of the ink composition on the glass substrate.

### (Example 4)

Ink composition 2 was obtained in the same manner as in Example 3 except that the heptane solutions obtained in Example 2 was used instead of the heptane solution obtained in Example 1. A light conversion layer 2 was obtained in the same manner as in Example 3 except that the ink composition 2 was used.

### (Comparative Example 3)

Ink composition C1 was obtained in the same manner as in Example 3 except that the heptane solutions obtained in Comparative Example 1 was used instead of the heptane solution obtained in Example 1. A light conversion layer c1 was obtained in the same manner as in Example 3 except that the ink composition C1 was used.

### (Comparative Example 4)

An ink composition C2 was obtained in the same manner as in Example 3 except that the heptane solution obtained in Comparative Example 2 was used instead of the heptane solution obtained in Example 1. A light conversion layer c2 was obtained in the same manner as in Example 3 except that the ink composition C2 was used.

### 5. Evaluation of ink composition and light conversion layer

The ink composition and the light conversion layer obtained above were evaluated for ejection stability, external quantum efficiency retention rate, and surface smoothness by the following procedure.

5-1. Ejection stability of ink composition

Using an inkjet printer (manufactured by Fuji Film Dimatix, "DMP-2831"), the ink composition was continuously ejected for 10 minutes and evaluated according to the following criteria.

Note that 16 nozzles are formed in the head portion of the inkjet printer for ejecting ink, and the amount of the ink composition used per nozzle per ejection was 10 pL.
A: Continuous ejection is possible (10 or more nozzles out of 16 nozzles can continuously eject)
B: Continuous ejection is not possible (out of 16 nozzles, the number of nozzles that can continuously eject is 9 or less)
C: Ejection not possible

### 5-2. External quantum efficiency retention rate of light conversion layer

The external quantum efficiency each of immediately after the formation of the obtained light conversion layer and after storage under the atmosphere for 10 days was measured as follows, and the external quantum efficiency retention rate of the light conversion layer (the value obtained by dividing the external quantum efficiency 10 days after the formation of the light conversion layer by the external quantum efficiency immediately after the formation of the light conversion layer) was calculated.

A blue LED (peak emission wavelength 450 nm; manufactured by CCS Inc.) was used as a surface emission light source, and a light conversion layer was installed on this light source with the glass substrate side facing down.

An integrating sphere was connected to a radiation spectrophotometer ("MCPD-9800" manufactured by Otsuka Electronics Co., Ltd.), and the integrating sphere was brought close to the light conversion layer installed on the blue LED. In this state, the blue LED was turned on, the quantum numbers of the excitation light and the emission (fluorescence) of the light conversion layer were measured, and the external quantum efficiency was calculated.

Note that the higher the external quantum efficiency retention rate, the higher the stability of the light conversion layer containing light-emitting particles to oxygen gas and water vapor.

### 5-3. Surface smoothness of light conversion layer

The surface of the obtained light conversion layer was observed with an atomic force microscope (AFM), and the surface roughness Sa was measured.

These results are summarized in Table 2 below.

**[Table 2]**

| | Ink Composition | Light conversion layer | Ejection stability | External Quantum Efficiency Retention Rate (%) | surface roughness Sa (µm) |
|---|---|---|---|---|---|
| Example 3 | 1 | 1 | A | 96 | 0.05 |
| Example 4 | 2 | 2 | B | 92 | 0.07 |
| Comparative Example 3 | C1 | c1 | C | 50 | 0.20 |
| Comparative Example 4 | C2 | c2 | C | 44 | 0.29 |

As shown in Table 1, it was found that the light-emitting particle dispersions of Examples 1 and 2 coated with the polymer layer were excellent in the quantum yield retention rate and the dispersion stability. Further, as shown in Table 2, the ink compositions prepared from the light-emitting particle dispersions of Examples 1 and 2 coated with the polymer layer have excellent inkjet ejection stability, and the formed light conversion layer was found that the external quantum efficiency retention rate and surface smoothness were excellent.

### Reference Signs List

- 100:: Light-emitting element
- 200:: EL light source unit
- 1:: Lower substrate
- 2:: Anode
- 3:: Hole injection layer
- 4:: Hole transport layer
- 5:: Light-emitting layer
- 6:: Electron transport layer
- 7:: Electron injection layer
- 8:: Cathode
- 9:: Light conversion layer
- 10:: Overcoat layer
- 11:: Upper substrate
- 12:: EL layer
- 90:: Light-emitting element
- 91:: Parent particle
- 911:: Nanocrystals
- 912:: Surface layer
- 92:: Polymer layer
- 701:: Condenser
- 702:: Drive transistor
- 705:: Common electrode
- 706:: Signal line
- 707:: Scanning line
- 708:: Switching transistor
- C1:: Signal line drive circuit
- C2:: Scanning line drive circuit
- C3:: Control circuit
- PE, R, G, B:: Pixel electrodes

## Claims

1. A method for producing light-emitting particles comprising:
step 1 of mixing a solution containing a raw material compound for semiconductor nanocrystals and a solution containing a compound containing Si and having a reactive group capable of forming a siloxane bond to precipitate perovskite-type semiconductor nanocrystals having light emitting properties and coordinate the compound on the surfaces of semiconductor nanocrystal, and then condensing the reactive group in the coordinated compound to obtain parent particles each having a surface layer having the siloxane bond formed on the surface of the semiconductor nanocrystal, and
step 2 of then forming a polymer layer by coating the surface of each parent particle with a hydrophobic polymer.

2. The method for producing light-emitting particles according to claim 1, wherein the average particle size of the semiconductor nanocrystals is 40 nm or less.

3. The method for producing light-emitting particles according to claim 1 or 2, wherein the surface layer has a thickness of 0.5 to 50 nm.

4. The method for producing light-emitting particles according to any one of claims 1 to 3, wherein the compound having a reactive group has a binding group that binds to a cation contained in the semiconductor nanocrystal.

5. The method for producing light-emitting particles according to claim 4, wherein the binding group is at least one of a carboxyl group, a mercapto group, and an amino group.

6. The method for producing light-emitting particles according to any one of claims 1 to 5, wherein the polymer layer has a thickness of 0.5 to 100 nm.

7. The method for producing light-emitting particles according to any one of claims 1 to 6, wherein
the hydrophobic polymer is obtained by carrying at least one polymerizable unsaturated monomer that is soluble in a non-aqueous solvent and becomes insoluble or sparingly soluble after polymerization, together with a polymer having a polymerizable unsaturated group soluble in a non-aqueous solvent on the surface of the parent particle and then polymerizing the polymer and the polymerizable unsaturated monomer.

8. The method for producing light-emitting particles according to claim 7, wherein the non-aqueous solvent contains at least one of an aliphatic hydrocarbon solvent and an alicyclic hydrocarbon solvent.

9. Light-emitting particles each comprising:
a parent particle composed of a perovskite-type semiconductor nanocrystal having light-emitting properties, and a surface layer which is composed of ligands coordinated on the surface of the semiconductor nanocrystal and in which ligand molecules form a siloxane bond, and
a polymer layer which covers the surface of the parent particle and is composed of a hydrophobic polymer.

10. The light-emitting particles according to claim 9, wherein
the hydrophobic polymer is a polymer having a polymerizable unsaturated group soluble in a non-aqueous solvent and at least one polymerizable unsaturated monomer that is soluble in a non-aqueous solvent and becomes insoluble or sparingly soluble after polymerization.

11. A light-emitting particle dispersion comprising the light-emitting particles according to claim 9 or 10 and a dispersion medium for dispersing the light-emitting particles.

12. An ink composition comprising the light-emitting particles according to claim 9 or 10, a photopolymerizable compound, and a photopolymerization initiator.

13. The ink composition according to claim 12, wherein the photopolymerizable compound is a photoradical polymerizable compound.

14. The ink composition according to claim 12 or 13, wherein
the photopolymerization initiator is at least one selected from the group consisting of alkylphenone compounds, acylphosphine oxide compounds, and oxime ester compounds.

15. A light-emitting element having a light-emitting layer containing the light-emitting particles according to claim 9 or 10.

16. The light-emitting element according to claim 15, further comprising a light source unit that irradiates the light-emitting layer with light.
